# EUROPEAN PATENT APPLICATION

(11) **EP 2 053 028 A1**
(43) Date of publication of application: **29.04.2009**
(21) Application number: 07792018.9
(22) Date of filing: 06.08.2007
(51) Int. Cl.: C04B 35/453, C23C 14/34

(54) **ZINC OXIDE SINTER, PROCESS FOR PRODUCING THE SAME, AND SPUTTERING TARGET**

(30) Priority: 11.08.2006 JP 2006219229; 23.03.2007 JP 2007075785
(71) Applicant: Hitachi Metals, Limited, Minato-ku Tokyo 105-8614 (JP)
(72) Inventor: FUKUSHIMA, Hideko, c/o HITACHI METALS, LTD., Saitama 360-0843 (JP)
(74) Representative: Möbus, Steffen
(86) International application number: PCT/JP2007/065345
(87) International publication number: WO 2008/018402

(57) **Abstract**

Densified zinc oxide ceramics can be obtained so that transparent electrodes with good characteristics can be obtained using the ceramics as a sputtering target. This manufacturing method is used to manufacture the zinc oxide ceramics doped with Al in ZnO. This method comprises, calcination powder production process by which calcination powder is produced after blending Al2O3 powder and a 1st ZnO powder and by calcinating them, and sintering process by which said zinc oxide ceramics are manufactured after sintering formed body composed of powder before the sintering which is made by blending said calcination powder and a 2nd ZnO powder. Here, the ceramics are manufactured not by sintering a formed body composed of Al2O3 powder and ZnO powder, but by sintering the formed body composed of the calcination powder containing ZnAl2O4 phase and ZnO powder.

## Description

### [Background of the invention]

### [Field of the Invention]

This invention relates to zinc oxide ceramics for a sputtering target by which transparent electrodes are formed by sputtering method, and also to a manufacturing method for the same.

### [Description of the Related Art]

Electrodes with both high conductivity and high transparency of light (transparent electrodes) are used for liquid crystal displays or solar cells. As materials with such characteristics, oxide materials, such as In₂O₃-SnO₂ (ITO), ZnO-B₂O₃ (BZO), and ZnO-Al₂O₃ (AZO), are known, for example. After such a material is formed as a thin film on a liquid crystal display or a solar cell by sputtering method, it is patterned and becomes a transparent electrode. In the sputtering process, a substrate (in this case, liquid crystal display etc.) on which a thin film is formed, is set facing the sputtering target (hereafter, target) in a sputtering apparatus. Then gas discharge is generated between these, and ions generated by this discharge collide with the surface of the target, and sputtered atoms (particles) by the impact are stuck on the facing substrate, the thin film is formed. This target is made of same material as the thin film (transparent electrode), and characteristics of the transparent electrodes are influenced by those of this target. Furthermore, this target is very expensive generally and that price influences the manufacturing cost of the liquid crystal display or the solar cell greatly. Therefore, the target must be cheep for making the manufacturing cost of liquid crystal display or solar cell low.

ITO is indium oxide (In₂O₃) in which tin (Sn) is doped, by using this, the transparent electrodes with light transparency of 85% or higher, with resistivity of about 1.0×10⁻⁴ Ω · cm are obtained, and these characteristics are enough for liquid crystal displays or solar cells. However, since indium (In) which is a main component of the target is expensive, the target becomes expensive. Since area of the target for forming electrodes used for liquid crystal displays or solar cells with large area must be large as these, the cost of the target makes them expensive. Therefore, transparent electrodes composed of cheap materials with equivalent characteristics, are needed.

BZO and AZO are the materials composed of zinc oxide (ZnO) which is a semiconductor in which boron (B), or aluminum (Al), which is n type impurity is doped, and these materials are cheaper than ITO because these were composed mainly of zinc, which is cheaper. As the sputtering target of these materials, ceramics are used widely, since the target with wide area can be produced easily. The ceramics of BZO or AZO are obtained by mixing raw material powders, molding them, and sintering the molded body at 1000 °C or higher. As raw material powders, ZnO powder mainly, and B₂O₃ powder or Al₂O₃ powder as the dopant are used. Similarly, ZnO-Ga₂O₃ (GZO) etc., here Ga₂O₃ is doped, is known as one of the zinc oxide materials.

However, it was difficult actually to obtain the transparent electrodes made of BZO or AZO with low resistivity repeatedly using these targets, and the resistivity became higher than that of ITO. Because, abnormal discharge arises frequently in the sputtering apparatus during the sputtering of these materials. Then, the thin film was hard to be formed repeatedly since the abnormal discharge occurred frequently during the sputtering of BZO or AZO. This abnormal discharge occurred, because the targets were inhomogeneous and some portion with different resistivity existed locally, then impedance of the discharge system varied during the sputtering. The portion with locally different resistivity corresponded to precipitates or voids in the target. Therefore, it is effective to make them small or to make number density of each of them small, for suppressing the abnormal discharge, and production methods for suppressing it were studied. The voids or the precipitates were not generated in ceramics after sintering the molded body made of only ZnO powder component, but were generated remarkably after sintering the body doped with B₂O₃ or Al₂O₃ for electrical conductivity. After considering these facts, production methods of BZO or AZO ceramics, by which homogeneous and densified ceramics of these were obtained, were proposed.

In BZO ceramics, since melting point (450 °C) of B₂O₃ is greatly lower than 1100 °C which is the temperature needed to sinter ZnO that is the main component of BZO, B₂O₃ is molten or evaporates during the sintering. Therefore, segregation or evaporation of B₂O₃ occurred in the ceramics, and voids were generated. Therefore, in patent documents 1 (JP,11-302835,A) and patent documents 2 (JP, 2004-175616,A), the production methods of the ceramics solving these problems are indicated. In these, after blending B₂O₃ and ZnO powder, or blending Al₂O₃ or Ga₂O₃, etc., with them further, calcination powder was formed after the calcination at low temperature of 900 °C or lower. This calcination powder and ZnO powder were further blended, and BZO ceramics were formed after sintering at high temperature under the atmosphere. In this calcination powder, the complex compound in which B and Zn are contained, or Al or Ga etc., were contained further, is formed. Since the melting point of this complex compound is higher than that of B₂O₃, local melting or evaporation is suppressed using this, and densified ceramics could be obtained. By using these ceramics for the target, the abnormal discharge was suppressed and the transparent electrodes of BZO with low resistivity were obtained.

Problem in production of the ceramics of AZO is that the sintering of ZnO itself which is the main component is disturbed by Al₂O₃ doping. Therefore, when the Al₂O₃ doping is heavy, densified ceramics were not obtained, and inhomegeneity causing the abnormal discharge arose. To solve the problem, in patent documents 3 (JP,7-258836,A), it is indicated that this inhomogeneity can be suppressed by optimizing these manufacturing conditions. Here, it was shown that by making second aggregate size of Al₂O₃ powder small, sintered particle size became smaller. By this method, ZnO itself could be easily sintered, and densified ceramics could be obtained. By using these ceramics for the target, the abnormal discharge was suppressed and the transparent electrodes with low resistivity could be given.

By the way, conducting films (transparent electrodes) made of such zinc oxides has poor heat resistance and poor moisture resistance in the air generally. Thereby, resistivity may rise gradually by heat or humidity. To solve the problem, in patent documents 4 (JP,7-3443,A) and 5 (JP, 8-111123,A), a sputtering target made of zinc oxides doped with Ga or Si by some amount, is indicated. The transparent films in which heat resistance and moisture resistance have been improved were obtained by doping such an element.

[Patent documents 1]JP,11-302835,A
[Patent documents 2]JP,2004-175616,A
[Patent documents 3]JP,7-258836,A
[Patent documents 4]JP,7-3443,A
[Patent documents 5]JP,8-111123,A

However, the ceramics of BZO or AZO produced by these methods were not densified enough.

By the method in which BZO is sintered using the calcination powder doped with B₂O₃, the melting point of the complex compound containing B formed in the calcination powder is higher than that of B₂O₃ (450°C), however, the melting point is lower than the temperature of 1100 °C or higher, which is required to obtain densified ZnO phase. Therefore, after blending the calcination powder and sintering them at this temperature, melting or evaporation in the calcination powder component occurred. Therefore, segregation or voids were generated in the ceramics, although these were less than that produced by blending B₂O₃ powder directly without the calcination powder. This problem is solved when the sintering is carried at low temperature, however, in this case, ZnO phase is not fully sintered, and densified ZnO phase cannot be obtained. Therefore, when doping with B₂O₃ whose melting point is low, it was difficult to obtain densified and homogeneous ceramics even by using the calcination powder.

In AZO doped with Al₂O₃ instead of B₂O₃, since the melting point of Al203 is about 2000 °C which is equivalent to that of ZnO, local melting or evaporation does not occur. Or, in GZO doped with Ga₂O₃ instead of B₂O₃, since the melting point of Ga₂O₃ is about 1740 °C which is equivalent to that of ZnO, local melting or evaporation does not occur. However, even when these ceramics were used for the target, the abnormal discharge was not suppressed enough and the transparent electrodes with resistivity low enough were not obtained. Because, in these ceramics, many voids were generated inside by different cause from the case of using B₂O₃, and these ceramics were not densified enough.

Therefore, it was difficult to obtain the zinc oxide ceramics densified enough such that the abnormal discharge is suppressed and the transparent electrodes can be obtained when using the ceramics as the sputtering target.

Although heat resistance and moisture resistance (weather resistance) were improved in the transparent electrodes formed by the sputtering target using the ceramics in which Ga or Si is doped in the zinc oxide, characteristics of them were not enough for use of the electrodes with both high weather resistance and low resistivity, and for the sputtering target by which the abnormal discharge is suppressed enough. To solve these problems, it is effective to dope Al etc. , as previously shown, and also to dope two or more species of dopant, however in this case, the abnormal discharge arises during the sputtering similarly as shown above.

This invention is made in view of these problems, and an purpose of this invention is to provide the invention which solves the above-mentioned problem.

### [Summary of the Invention]

This invention is made in view of this problem, and an object of this invention is to provide the invention which solves the above-mentioned problem.

An aspect in accordance with the present invention provides,
a manufacturing method for zinc oxide ceramics, in which said ceramics contain more than one of Al, Ga, In, Ti, Si, Ge and Sn as dopants in ZnO, comprising;
calcination powder production process by which calcination powder is produced after blending oxide powder made of oxide of said dopant and a 1st ZnO powder, and calcinating them at temperature of 900 ∼ 1300°C,
sintering process by which said zinc oxide ceramics are manufactured after sintering at temperature of 1100 ∼ 1600 °C formed body composed of powder before the sintering which is made by blending said calcination powder and a 2nd ZnO powder.
Moreover, in the manufacturing method for zinc oxide ceramics of the present invention, wherein, mixing molar ratio of said 1st ZnO powder to said oxide powder is 1 or more, and is 200 or less in said calcination powder production process.
Moreover, in the manufacturing method for zinc oxide ceramics of the present invention, wherein, BET specific surface area of said 1st ZnO powder is in a range of 2 ∼ 30m²/g.
Moreover, in the manufacturing method for zinc oxide ceramics of the present invention, wherein, BET specific surface area of said oxide powder is in a range of 2 ∼ 100m²/g.
Moreover, in the manufacturing method for zinc oxide ceramics of the present invention, wherein, said oxide powder is made of at least one selected among Al₂O₃, Ga₂O₃, In₂O₃, TiO₂, SiO₂, GeO₂, and SnO₂.
Moreover, in the manufacturing method for zinc oxide ceramics of the present invention, wherein, calcination in said calcination powder production process is carried in non-reducing atmosphere.
Moreover, in the manufacturing method for zinc oxide ceramics of the present invention, wherein, BET specific surface area of said powder before the sintering is in a range of 1 ∼ 20m²/g.
Moreover, in the manufacturing method for zinc oxide ceramics of the present invention, wherein, sintering in said sintering process is carried in non-reducing atmosphere.
Moreover, in the manufacturing method for zinc oxide ceramics of the present invention, wherein, said dopants comprise a 1st dopant which is one selected among Al, Ga, In, Ti, Si, Ge, and Sn, and a 2nd dopant which is one selected among Al, Ga, In, Ti, Si, Ge, and Sn except for said 1st dopant, wherein, said oxide powder in said calcination powder production process comprises a 1st oxide powder made of oxide of said 1st dopant and a 2nd oxide powder made of oxide of said 2nd dopant.
Moreover, in the manufacturing method for zinc oxide ceramics of the present invention, wherein, a 1st calcinated body is produced after blending said 1st oxide powder and said 1st ZnO powder and calcinating them at temperature of 900 ∼ 1300 °C, and a 2nd calcinated body is produced after blending said 2nd oxide powder and 3rd ZnO powder and calcinating them at temperature of 900 ∼ 1300°C, and said calcination powder is produced by mixing said 1st calcinated body and said 2nd calcinated body in said calcination powder production process.
Moreover, in the manufacturing method for zinc oxide ceramics of the present invention, wherein, mixing molar ratio of sum of said 1st ZnO powder and said 3rd ZnO powder to sum of said 1st oxide powder and said 2nd oxide powder is 1 or more, and 200 or less, in said calcination powder production process.
Moreover, in the manufacturing method for zinc oxide ceramics of the present invention, wherein, both mixing molar ratio of said 1st ZnO powder to said 1st oxide powder, and mixing molar ratio of said 3rd ZnO powder to said 2nd oxide powder, are 1 or more, and 200 or less, in said calcination powder production process.
Moreover, in the manufacturing method for zinc oxide ceramics of the present invention, wherein, BET specific surface area of said 3rd ZnO powder is in a range of 2 ∼ 30m²/g.
Moreover, in the manufacturing method for zinc oxide ceramics of the present invention, further comprising;
a 1st mixing process, in which a 1st mixture solution is produced by mixing said calcination powder produced by said calcination powder production process with a solvent,
a 2nd mixing process, in which a 2nd mixture solution is produced by mixing a 2nd ZnO powder with said 1st mixture solution,
wherein, a powder produced from said 2nd mixture solution is formed into a formed body, and said ceramics are manufactured by sintering said formed body.
Moreover, in the manufacturing method for zinc oxide ceramics of the present invention, wherein, said 2nd mixture solution is produced by mixing said 1st mixture solution with another solution in which said 2nd ZnO powder is mixed with a solvent.
Another aspect in accordance with the present invention provides,
a manufacturing method for zinc oxide ceramics, in which said ceramics contain more than one of Al, Ga, In, Ti, Si, Ge and Sn as dopants in ZnO, comprising;
mixing a powder made of complex oxide composed mainly of both said dopant and Zn, with ZnO powder,
forming said mixed powder into a formed body,
manufacturing said ceramics by sintering said formed body at a temperature of 1100 ∼ 1600°C.
Moreover, in the manufacturing method for zinc oxide ceramics of the present invention, wherein, said complex oxide is made of at least one among ZnAl₂O₄, ZnGa₂O₄, ZnIn₂O₄, Zn₂TiO₄, Zn₂SiO₄, Zn₂GeO₄, and Zn₂SnO₄.
Another aspect in accordance with the present invention provides,
a zinc oxide ceramics manufactured by said manufacturing method for zinc oxide ceramics.
Another aspect in accordance with the present invention provides,
a zinc oxide ceramics containing more than one of Al, Ga, In, Ti, Si, Ge and Sn as dopants in ZnO,
wherein, both precipitates containing complex oxide of said dopant and Zn and voids around said precipitates, are formed inside,
wherein, ratio of said precipitates in which diameter of equivalent circle is 3µm or larger to all of said precipitates is 20% or less, and ratio of said voids in which diameter of equivalent circle is 3µm or larger to all of said voids, is 50% or less.
Moreover, in the zinc oxide ceramics of the present invention,
wherein, composition ratio of said dopant in said ceramics is 0.5 ∼ 10wt%, expressed as oxides.
Another aspect in accordance with the present invention provides,
a zinc oxide ceramics containing one among Al, Ga, In, Ti, Si, Ge and Sn as a 1st dopant, and also containing one among Al, Ga, In, Ti, Si, Ge and Sn except for said 1st dopant as a 2nd dopant in ZnO,
wherein, a co-precipitation part in which a 1st precipitate containing complex oxide of said 1st dopant and Zn, and a 2nd precipitate containing complex oxide of said 2nd dopant and Zn, are co-existing, is formed in zinc oxide phase which is a main phase.
Moreover, in the zinc oxide ceramics of the present invention,
wherein volume ratio of said co-precipitation parts whose diameter of equivalent circle is 10µm or smaller is 90% or more.
Moreover, in the zinc oxide ceramics of the present invention,
wherein, composition ratio of said 2nd dopant in said ceramics is 0.05 ∼ 5wt%, expressed as oxides.
Moreover, in the zinc oxide ceramics of the present invention, wherein, composition ratio of sum of said 1st dopant and said 2nd dopant in said ceramics is 0.5 ∼ 10wt%, expressed as oxides.
Moreover, in the zinc oxide ceramics of the present invention, wherein, density of said ceramics is 5.5g/cm³ or higher.
Another aspect in accordance with the present invention provides,
a sputtering target made of said zinc oxide ceramics.

### [Effect of the Invention]

Since these inventions are composed as mentioned above, densified zinc oxide ceramics can be obtained. And transparent electrodes with excellent characteristics can be obtained using the ceramics as a sputtering target. [Detailed Description of the Preferred Embodiments]

By analysis of ceramics of ZnO-Al₂O₃ (AZO) or ZnO-Ga₂O₃ (GZO) formed by conventional manufacturing method, inventors have found that complex compound phase precipitates such as that made of ZnO and Al₂O₃ in AGO or that made of ZnO or Ga₂O₃ in GZO are found, and voids are formed only around the precipitates. By investigating mechanism for the generation of the voids, and densified ceramics could be obtained by making size of the precipitates or the voids small.

And inventors manufactured the sputtering target by the previous manufacturing method in which G₂O₃ was doped to improve the weather resistance, and analyzed the target after the sputtering using it. As a result, it was found that, among complex oxides in the ceramics, especially ZnGa₂O₄ phase is eroded more selectively, compared with ZnAl₂O₄ phase, therefore the convex shaped nodules were formed on the target surface, and the nodules caused the abnormal discharge. After analyzing this selective erosion, coexistence region in which both ZnGa₂O₄ phase and ZonAl₂O₄ phase exist is formed in the ceramics, and selective erosion of ZnGa₂O₄ phase was suppressed by manufacturing method of this invention. Thereby, the abnormal discharge was suppressed further.

Hereafter, the best forms for carrying out this invention are explained.

### (The 1st embodiment)

Manufacturing method for the zinc oxide ceramics concerning the 1st embodiment of this invention is a production method for the zinc oxide ceramics made of ZnO doped with Al₂O₃, or a manufacturing method for the zinc oxide ceramics made of ZnO doped with Ga₂O₃. This manufacturing method comprises, calcination powder production process in which 1st ZnO powder and Al₂O₃ etc. , powder are blended and calcinated, and sintering process in which 2nd ZnO powder and calcination powder produced by the calcination powder production process are blended and molded into a molded body and the molded body is sintered.

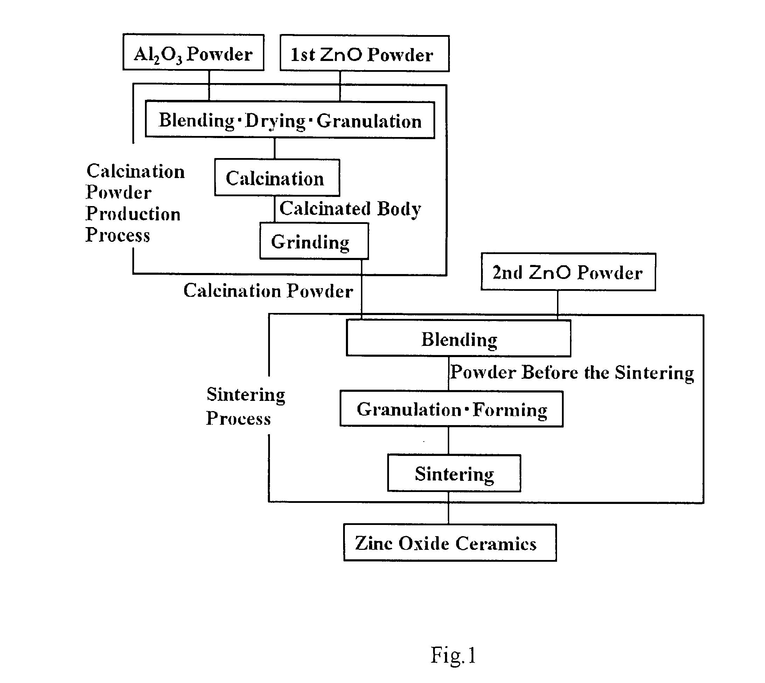

In the manufacturing method for the zinc oxide ceramics concerning the 1st embodiment of this invention, Al₂O₃ or Ga₂O₃ is used as the oxide powder (dopant to the ceramics). Here, the ceramics are produced not by blending Al₂O₃ powder and ZnO powder, molding, and sintering the molded body into the ceramics, instead, the ceramics is produced by producing at first calcination powder in which ZnAl₂O₄ phase or ZnGa₂O₄ phase is contained, and by blending the calcination powder and ZnO powder, molding, and sintering. Therefore, this manufacturing method comprises the calcination powder production process and the sintering process, as shown in figure 1.

In the calcination powder production process, at first, the 1st ZnO powder and, Al₂O₃ powder or Ga₂O₃ are blended, granulated, and calcinated in the air, and calcinated boby is obtained. Next, this calcinated body is ground into the calcination powder whose particle size is set as desired. In this calcinated body, ZnAl₂O₄ which is a complex compound of ZnO and Al₂O₃ with spinel structure, or GaAl₂O₄ similarly, is formed.

The 1st ZnO powder used here is preferred to be composed of ZnO with wurtzite structure, and, BET-specific surface area is preferred to be in the range of 2 ∼ 30m²/g. The purity is preferred to be 99.9% or higher.

Al₂O₃ powder is preferred to be composed of Al₂O₃ such as α -alumina, β-alumina, or θ-alumina, and the BET-specific surface area is preferred to be in the range of 2 ∼ 100m²/g Especially among these, α-alumina is preferred because ZnAl₂O₄ may be formed easily. The purity is preferred to be 99.9% or higher, too.

When Ga is used as the dopant, Ga₂O₃ powder is preferred to be composed of a or β-Ga₂O₃. The BET-specific surface area, purity, etc. are the same as those of Al₂O₃.

The molar ratio of ZnO/Al₂O₃ (or Ga₂O₃) which is a blending ratio of the 1st ZnO powder and the Al₂O₃ (Ga₂O₃) powder, is preferred to be in the range of 1 ∼ 200, and is preferred to be in the range of 1 ∼ 30 especially. The powder after the blending is mixed and granulated, then calcinated at the temperature of 900 ∼ 1300 °C (calcination), and the calcinated body is produced.

The atmosphere for this calcination is preferred to be non-reducing atmosphere, and is preferred to be the air or oxygen atmosphere especially. In the calcinated body, ZnAl₂O₄ which is a complex compound with spinel structure is formed by solid phase reaction between ZnO particles and Al₂O₃ particles, or ZnGa₂O₄ is formed similarly by that between ZnO particles and Ga₂O₃ particles. The calcination time is preferred to be in the range of 1 to 5 hours. In the calcinated body, particles are bonded by the calcination. This calcinated body is ground by some mechanical processes, such as a ball mill process, and the particle size (particle diameter) is made to a desired size, and the calcination powder is obtained. And the BET-specific surface area of the calcination powder is preferred to be in the range of 2-30m²/g. Furthermore, other method, such as that using a vibration mill, which can control the BET-specific surface area, can be used similarly. If the calcinated body is obtained in the powder state with suitable particle diameter, this mechanical process is unnecessary. The state of the calcinated body depends on ratio of the 1st ZnO powder to the oxide powder. When this ratio is large, ZnO phase are generated more, and grains of the ZnO phase are gown by the sintering, and the particle of ZnO phase becomes large, therefore, this particle size adjustment is needed to set the BET-specific surface area in above-mentioned range.

Here, the BET-specific surface area of each powder was defined as a total surface area of the powder per unit mass, measured by the BET method, as determined by the method shown in JISR1626 (Japanese Industrial Standards).

After blending the calcination powder given by the previous process and 2nd ZnO powder, granulating, and forming them into a formed body, this formed body is sintered in non-reducing atmosphere, such as in the air, in oxygen, or inert gas of nitrogen or argon etc., and the zinc oxide ceramics are produced in the sintering process. Here, the caramics are formed as a desired shape, such as the shape of the sputtering target.

The 2nd ZnO powder is preferred to be composed of ZnO with wurtzite structure, and, the BET-specific surface area is preferred to be in the range of 2 ∼ 30m²/g, as the 1st ZnO powder. The purity of the 2nd ZnO powder is preferred to be 99.9% or higher.

In blending the calcination powder and the 2nd ZnO powder, it is preferred to blend them by addition of 1 wt. % of polyvinyl alcohol as a binder, and to blend them by a ball mill etc. Slurry produced by these processes are dried, granulated, and formed into a desired shape by a pressing method etc. Shape and size of the formed body can be made arbitrary, for example, planar type of 127mmx381mmx5mm or larger, can be made for the target for the transparent electrodes of large area liquid crystal displays. Zinc oxide ceramics are obtained by sintering this formed body at the temperature of 1100∼1600 °C (sintering). The sintering time is preferred to be 1 to 5 hours.

When blending and mixing the calcination powder and the 2nd ZnO powder as aforementioned, the states of the sintered formed body can be optimized by adjusting the particle size of a powder before the sintering which is a mixture of these powders. In this case, the BET specific surface area of the powder before the sintering is preferred to be 1∼20m²/g.

Why densified zinc oxide ceramics without large voids and precipitates are given by this manufacturing method, is shown below.

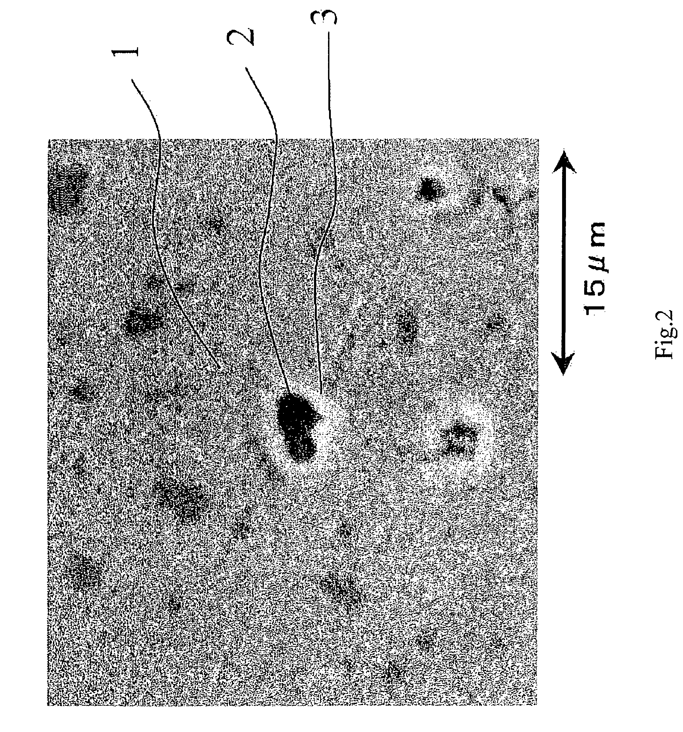

AZO ceramics were manufactured by conventional manufacturing method in which ZnO powder and Al₂O₃ powder are blended directly instead, here ZnO powder (wurtzite structure, the BET specific surface area = 5m²/g), Al₂O₃ powder (α-alumina, the BET specific surface area = 11m²/g) were blended with the weight ratio of 98:2, formed, and sintered in the air at 1300 °C, and AZO ceramics were manufactured. A SEM photograph of the mirror polished cross section of the ceramics is shown in figure 2. By analysis of SEM (scanning electron microscope) - EDX (energy dispersive X-ray spectroscopy), it was found that the portion 1 which occupied most in figure 2 is ZnO with wurtzite structure, and it had uniform and densified structure. On the other hand, the portion 2 which exists partially was precipitate made of ZnAl₂O₄ phase with spinel structure, and voids 3 were found around them. Further, Al₂O₃ component which existedbefore the sintering could not be seen. Therefore, Al₂O₃ component which existed before the sintering may be spent to form ZnAl₂O₄ phase, and a part of that may be diffused in ZnO phase 1. The density of the ceramics was 5.45g/cm³.

By these results, it is found that in AZO ceramics by the conventional manufacturing method, doped Al₂O₃ reacts with ZnO and ZnAl₂O₄ is formed, and a part of Al diffuses in ZnO phase and becomes a conductive dopant. It turned out that the voids are formed around the precipitation made of ZnAl₂O₄. Also it turned out that similar structure (ZnGa₂O₄ precipitates etc.) is formed in GZO ceramics as AZO ceramics by the conventional manufacturing method.

In AZO ceramics, voids may not be formed when the grains are grown enough, however, in this case, many voids with aforementioned form were seen. The cause by which these voids 3 are formed, may be volume shrinkage while ZnAl₂O₄ phase is formed by solid phase reaction between ZnO particle and Al₂O₃ particle. Since the melting points of both ZnO and Al₂O₃ are around 2000 °C, ZnAl₂O₄ is formed by the solid phase reaction between ZnO grain and Al₂O₃ grain when the sintering. Then, the volume of ZnAl₂O₄ is smaller than sum of that of ZnO grain and that of Al₂O₃, what is called volume shrinkage arises. On the other hand, the amount of ZnO powder is more than that of Al₂O₃ powder, ZnO particles not forming ZnAl₂O₄ are bonded to each other and densified ZnO phase 1 is formed. Therefore, voids 3 are formed around ZnAl₂O₄ precipitates. When the ceramics with this structure are used for the sputtering target, the abnormal discharge may arise because of the void 3 especially. Furthermore, resistivity of ZnAl₂O₄ phase is different from that of ZnO phase, therefore, when relatively large ZnAl₂O₄ phases are distributed nonuniformly, the abnormal discharge may arise because of the precipitates. Voids are hardly seen except for around ZnAl₂O₄ phase 2, and ZnO phase 1 has almost densified structure, the density of the zinc oxide ceramics is low because of existence of the voids 3. As aforementioned, when ZnO powder and B₂O₃ powder were directly blended and sintered, voids were formed because B₂O₃ with low melting point was molten, segregated, or evaporated selectively. On the other hand, it was found that these voids were formed because ZnAl₂O₄ phase is formed when blending Al₂O₃ powder, also these voids were formed because ZnGa₂O₄ phase is formed when blending Ga₂O₃ powder, therefore void formation mechanism is different.

By these results, by eliminating the effect of the volume shrinkage during the formation of ZnAl₂O₄ phase or ZnGa₂O₄ phase, voids 3 may not be formed and densified zinc oxide ceramics may be obtained. Therefore, in the manufacturing method of this embodiment, calcination powder production process is carried at first, here calcination powder mainly composed of ZnAl₂O₄ or ZnGa₂O₄ with spinel structure is produced. Unlike the calcination process using B₂O₃ powder, this calcination temperature may be set as low as possible, as ZnAl₂O₄ phase or ZnGa₂O₄ phase with excellent crystality is formed, because the purpose of this process is to form ZnAl₂O₄ or ZnGa₂O₄ phase. This temperature is preferred to be high to form ZnAl₂O₄ or ZnGa₂O₄ phase with excellent crystality, however, the BET-specific surface area of the caicinated body becomes small and activity of the powder will be less, and, the degree of sintering will be worse. After blending this calcination powder and ZnO powder again and sintering, zinc oxide ceramics are obtained. By this manufacturing method, because formation of ZnAl₂O₄ phase or ZnGa₂O₄ phase during the sintering is suppressed to the minimum, voids around ZnAl₂O₄ phase or ZnGa₂O₄ phase become hard to be formed, or even if the voids are formed, diameter of the voids becomes small relatively. Furthermore, size of the precipitates made of ZnAl₂O₄ becomes smaller and more uniform when forming these in the calcination, compared with the case in which these are formed in the sintering process.

As mentioned above, characteristic of the manufacturing method of this embodiment is, to use a powder containig ZnAl₂O₄ with spinel structure for Al component doping, instead of using Al₂O₃ powder. Or, it is, to use a powder containing ZnGa₂O₄ with spinel structure for Ga component doping, instead of using Ga₂O₃ powder.

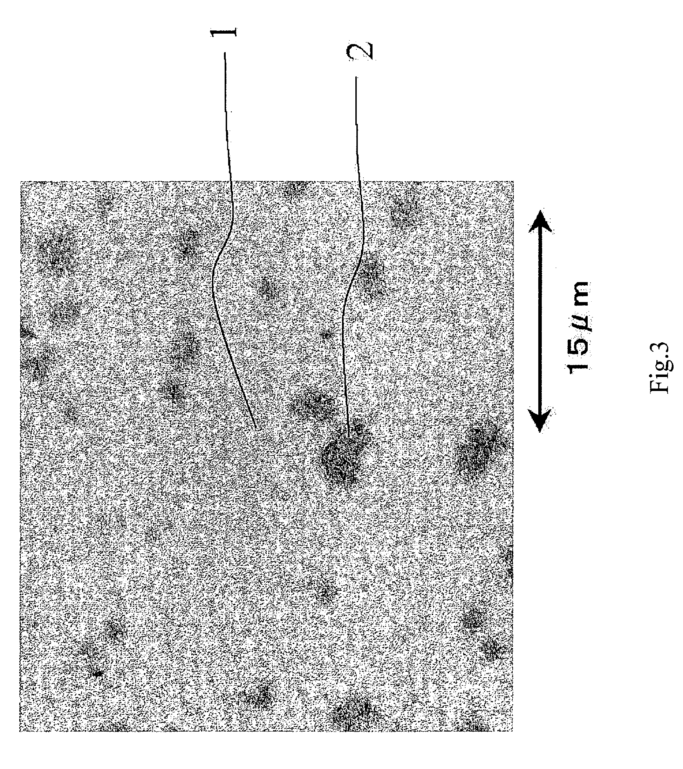

Similarly as figure 2, SEM photograph of the mirror polished cross section of the ceramics manufactured by the manufacturing method of this embodiment using Al₂O₃, is shown in figure 3. In figure 3, the portion 1 corresponds to ZnO phase with wurtzite structure, and the portion 2 corresponds to ZnAl₂O₄ phase with spinel structure. Although these are the same as these in figure 2, voids cannot be seen around ZnAl₂O₄ phase 2. Measured density of this ceramics was 5.6g/cm³. Thus, densified zinc oxide ceramics were obtained by the manufacturing method of this embodiment. Because, ZnAl₂O₄ phase was not formed during the sintering process. Furthermore, not only the voids are suppressed, but it is found that existence ratio of precipitates 2 made of ZnAl₂O₄ phase with large diameter is decreased.

The calcinated body after the calcination in the manufacturing method of this embodiment contains ZnAl₂O₄ phase, but may contain ZnO phase further as one of other phases. However, since these phases are calcinated in the powder state, then they are ground into a powder state again, therefore, voids as shown in figure 2 are not formed in the ceramics.
Or, by setting the BET specific surface area of the calcination powder 2∼30m²/g, voids as shown in figure 2 are not formed in the ceramics even if ZnAl₂O₄ phase is formed further during the sintering.

Moreover, after blending this calcination powder and sintering later, it was found that grain growth in ZnO phase which was a main component of the ceramics was enough, and densified ZnO phase 1 was given. Therefore, it was found that distribution of the complex oxide phase was uniform and zinc oxide ceramics without voids were obtained. Therefore, densified zinc oxide ceramics in which distribution of the complex oxide phase is uniform were obtained by the manufacturing method of this embodiment. Therefore, when these zinc oxide ceramics are used for the sputtering target, the abnormal discharge can be suppressed.

In the zinc oxide ceramics manufactured by the manufacturing method of this embodiment, since formation of large precipitates or large voids is suppressed, the abnormal discharge when using this for the sputtering target can be suppressed. Concretely, ratio of the precipitates in which diameter of equivalent circle is 3µm or larger, to all precipitates containing the complex oxide, can be 20% or less, and similarly, ratio of the voids in which diameter of equivalent circle is 3µm or larger, to all voids, can be 50% or less. Here, diameter of equivalent circle means a equivalent diameter of a circle with area equal to the precipitate or void in the cross section as shown in figure 2 or figure 3. Namely, the diameter of equivalent circle equals to (4 · S/π)^{1/2}, here, S is a area of the precipitate containing the complex oxide or the void shown in the SEM photograph of the mirror polished cross section of the ceramics. In this measurement, image-analysis software (tradename Win ROOF: made by MITANI SANGYO, Japan) was used, and the SEM photograph data as shown in figures 2 or 3 was digitized, and area of the precipitate or the void was measured in arbitrarily chosen part with area of 2x10⁻³mm² in the zinc oxide ceramics, and the diameter of equivalent circle was calculated.

If the ratio of the precipitates (complex oxides) in which diameter of equivalent circle is 3µm or larger in the above mentioned part is 20% or larger, then large complex oxide containing zinc with different resistivity is distributed nonuniformly and locally in the ZnO phase, and that causes the abnormal discharge. Similarly, if the ratio of the voids in which diameter of equivalent circle is 3µm or larger in the above mentioned part is 50% or larger, then large void is distributed nonuniformly and locally, and that causes the abnormal discharge, too.

Furthermore, in the zinc oxide ceramics manufactured by the manufacturing method of this embodiment, voids are small and number density of the voids is small, therefore the ceramics are densified. There are many isotopes of Zn, density of ideal zinc oxide cannot be determined uniquely and this density may be around 5.60g/cm³, then the density of the ceramics can be made 5.50 g/cm³ or higher.

The calcination powder production process is carried to form ZnAl₂O₄ with spinel structure by solid-state reaction between Al₂O₃ particles made of α-alumina, β-alumina, or θ-alumina, and ZnO particles with wurtzite structure. Or, when Ga is used as the dopant, ZnGa₂O₄ is similarly formed using α or β-Ga₂O₃ particles. Therefore, the BET specific surface area of the 1st ZnO powder is preferred to be 2∼30m²/g. If this is smaller than 2m²/g, the precipitates made of ZnAl₂O₄ etc., becomes large and the abnormal discharge arises by these precipitates. If it is larger than 30m²/g, ZnO will act as an agglomerated particle and ZnO will not be distributed uniformly, then ZnAl₂O₄ phase etc., becomes larger and causes the abnormal discharge. And the BET specific surface area of the oxide powder (Al₂O₃ powder, Ga₂O₃ powder) is preferred to be 2∼100m²/g. If this is smaller than 2m²/g, the precipitates made of ZnAl₂O₄ etc. , becomes large and the abnormal discharge arises by these precipitates. If this is larger than 100m²/g, Al₂O₃ etc., will act as an agglomerated particle and ZnO will not be distributed uniformly, then ZnAl₂O₄ phase etc. , becomes larger and causes the abnormal discharge.

The calcination temperature in the calcination powder production process is preferred to be 900-1300 °C, and the calcination time is preferred to be 1 to 5 hours. When this temperature is lower than 900 °C, or when the time is shorter than 1 hour, ZnAl₂O₄ with spinel structure etc., will not be formed enough during the calcination, and Al₂O₃ phase will remain, therefore, ZnAl₂O₄ or ZnGa₂O₄ will be formed during the sintering later. Therefore, voids may be formed around ZnAl₂O₄ phase etc. , formed during the sintering. When this temperature is higher than 1300 °C, or when the calcination time is longer than 5 hours, the BET specific surface area of the calcinated body will become small, and densified ceramics will be hard to to be obtained by the sintering. Although the atmosphere of the calcination is preferred to be non-reducing atmosphere, especially is preferred to be the air to lower the production cost, or may be pressurized atmosphere. Or it is preferred to be oxygen atmosphere, or inert gas such as argon or nitrogen etc., atmosphere, instead of the air.

In the calcinated body obtained by the calcination, complex oxide ZnAl₂O₄ or ZnGa₂O₄ with spinel structure by solid-state reaction between ZnO and Al₂O₃ or Ga₂O₃. Therefore, molar ratio of the 1st ZnO powder to the Al₂O₃ powder or the Ga₂O₃ powder is preferred to be 1:1, which corresponds to the stoichiometric composition. If this molar ratio becomes Al₂O₃ rich or Ga₂O₃ rich, residual Al₂O₃ phase etc., remains in the calcination powder. Then, in the sintering process later, ZnAl₂O₄ etc., is formed by solid-state reaction between this Al₂O₃ phase etc., and the 2nd ZnO powder, and voids are formed simultaneously, will cause the abnormal discharge. On the other hand, if the ratio becomes ZnO rich, since the Al₂O₃ composition etc., in the calcination powder becomes small, sintering of ZnO itself progress during the calcination process and the degree of sintering after the sintering process becomes worse, then densified ceramics are hard to be obtained. Therefore, it is necessary to crush the calcinated body into powder in this case. Therefore, this ratio is preferred to be ZnO:Al₂O₃, or ZnO:Ga₂O₃ is 1:1 ∼ 200:1, and is preferred to be 1:1 ∼ 30:1 more. If the BET specific surface area of the calcination powder is less than 2m²/g, voids will be formed between ZnO particles and will cause the abnormal discharge. If it is more than 30m²/g, these powders will agglomerate, and dispersibility will be worse, and the organization of the compound oxide phase in the ceramics will become nonuniform.

The sintering process is a process to obtain the formed ZnO ceramics.
The BET specific surface area of the calcination powder used here can be adjusted using the mechanical process such as a ball mill process, by which the calcinated body is ground. By the ball mill process, this is adjusted by controlling the processing time. For example, calcination powder with the BET specific surface area of 5m²/g can be obtained after the process for 40 hours using alumina balls. Other methods which can adjust the diameter of particles similarly, for example, a vibrating mill process can be used instead of the ball mill process.

The BET specific surface area of the 2nd ZnO powder is preferred also to be 2 ∼ 30m²/g. If this is less than 2m²/g, densified ceramics cannot be obtained in the sintering process. If this is more than 30m²/g, density of the formed body becomes low after the forming, therefore densified ceramics cannot be obtained in the sintering process either. This ZnO powder may become the main component of the zinc oxide ceramics obtained finally.

By setting the mixing ratio of the 2nd ZnO powder to the calcination powder in the sintering process, composition ratio of Al or Ga in the zinc oxide ceramics can be made 0.5 - 10wt%, expressed as oxides. However, composition ratio of Al etc., in the calcination powder depends on the mixing ratio in the calcination powder production process. If the composition ratio of Al or Ga in the zinc oxide ceramics is less than 0.5wt%, or is more than 10wt%, expressed as oxides, resistivity of the film formed by sputtering using said ceramics as the target will become high, 10⁻² Ω · cm or higher.

The calcination powder and the 2nd ZnO powder can be blended with a predetermined mixing ratio, using polyvinyl alcohol for example as a binder. Here, these can be mixed uniformly by ball mill process for 20 hours. Other methods by which the mixing can be done similarly, for example, a vibrating mill process can be used instead of the ball mill process. Then, after pressing and forming the mixture, the formed body with a predetermined shape can be obtained.

This sintering temperature is preferred to be 1100 ∼ 1600 °C. If this temperature is lower than 1100 °C, sintering of ZnO which is the main component will not be done enough, and densified zinc oxide ceramics will not be obtained. If this temperature is higher than 1600 °C, ZnO component will decompose or sublimate and the composition of the ceramics will vary from the desired composition. The sintering temperature is preferred to be higher than the calcination temperature to make the ceramics densified, and temperature difference between these is preferred to be 200 °C or larger. If this temperature difference is small, densified ceramics will not be obtained after the sintering process, and voids may be formed between ZnO phases. Although the atmosphere of the sintering is preferred to be non-reducing atmosphere, especially is preferred to be the air to lower the production cost, or may be pressurized atmosphere. Or it is preferred to be oxygen atmosphere etc., or inert gas such as argon or nitrogen etc., atmosphere, instead of the air. The sintering time is preferred to be 1 to 5 hours. If this time is shorter than 1 hour, grain growth of ZnO will not progress enough, and densified zinc oxide ceramics are hard to be obtained. If this time is longer than 5 hours, decomposition or sublimation of ZnO will arise and the composition of the ceramics will vary from the desired composition.

Generally, voids in the ceramics are hard to be formed if the atmosphere during the sintering is highly pressurized or normally pressurized, and are easy to be formed if the atmosphere is depressurized, or especially reducing atmosphere. In the calcination process in the calcination powder production process, voids are not formed because ZnO and Al₂O₃, or Ga₂O₃ is in a powder state. Therefore, the sintering is preferred to be done in non-reducing atmosphere. When the sintering is done in the air, used equipments become simpler compared with those in which pressurized atmosphere is used, therefore this process can be done with low cost. Therefore, densified zinc oxide ceramics can be obtained at low cost.

For example, also in the manufacturing methods for BZO ceramics shown in patent documents 1 and 2, calcination powder was mixed with ZnO powder, and zinc oxide ceramics were formed. However, in these cases, in producing the calcination powder, the calcination temperature must be lower than that of this embodiment, because it contains B₂O₃ with low melting point, 450 °C. On the other hand, for enough grain growth of ZnO, the sintering temperature must be higher than the calcination temperature. Therefore, complex oxide containing Zn is formed newly during the sintering, and voids are formed by local volume shrinkage then. Then, although ZnO phase becomes densified, voids are formed around the complex oxide phase, and densified ceramics cannot be obtained. On the other hand, in the manufacturing method of this embodiment, for example, by setting the BET specific surface area when making the calcinated body into the calcination powder after the calcination by grinding, and by setting the temperature difference between 200 °C or higher, the ratio of the voids in which diameter of equivalent circle is 3 µm or larger can be made less than 50%. Therefore, densified zinc oxide ceramics can be obtained. Therefore, in the manufacturing method of this embodiment, B2O3 with low melting point is not doped by amount more than that of unintentionally doping, instead, Al₂O₃ or Ga₂O₃ with equivalent melting point to ZnO, is doped. And the sintering can be done at high temperature, 1100 °C or higher, because melting point of ZnAl₂O₄ or ZnGa₂O₄ which is a main component of the calcination powder is as high as ZnO. In this case, since grain growth of ZnO proceeds enough, densified ZnO phase can be obtained.

These zinc oxide ceramics can be manufactured using general equipments (ball mill, furnace etc.,) by which conventional ceramics are manufactured. Therefore, similarly as conventional ceramics, these ceramics with large area can be obtained easily, for example, a sputtering target even with a size of several 10cm or larger can be obtained. Transparent electrodes with both high light transparency and low resistance can be formed on large area liquid crystal displays or solar cells using the sputtering target. Since the main component of this sputtering target are not expensive indium but cheap zinc, this target can be manufactured at low cost. Therefore, transparent electrodes with excellent characteristics can be obtained at low cost.

Instead of the calcination powder in aforementioned manufacturing method, ZnAl₂O₄ powder with spinel structure produced by some other method may be blended with the ZnO powder in the sintering process, and densified zinc oxide ceramics can be obtained similarly. As one of other methods, for example, ZnAl₂O₄ ceramics may be produced using some powder material except for ZnO or Al₂O₃, and the ZnAl₂O₄ ceramics may be ground into powder. Or, after getting mixture in a powder state by the coprecipitation method using hydrates containing Zn or Al, ZnAl₂O₄ ceramics may be produced using the mixture, and the ceramics may be ground into powder.
Or, some method except for sintering method using powder, can be used, for example, polycrystalline ZnAl₂O₄ may be produced by CVD (Chemical Vapor Deposition) method, the polycrystalline may be ground into powder, and the powder may be used instead of the calcination powder. Here, in the manufacturing method of this embodiment shown in figure 1, these ZnAl₂O₄ powder may be used instead of the calcination powder in the sintering process. Similarly, ZnGa₂O₄ powder can be used instead of the calcination powder.

Although Al or Ga was used as the dopant for n-type conductivity in ZnO in above-mentioned examples, other dopants whose oxide has melting point is as high as ZnO or Al₂O₃, and by which complex oxide can be formed with ZnO, may be also used similarly as Al or Ga, and densified zinc oxide ceramics can be obtained similarly. For example, indium (In) which belongs to the same group IIIB as Al can be similarly used as the dopant for n-type conductivity. In this case, indium oxide (In₂O₃) powder is used for production of the calcination powder instead of Al₂O₃ powder, complex oxide which is the main component of the obtained calcination powder is ZnIn₂O₄. Since this complex oxide also has spinel structure and high melting point of 1000 °C or higher, similar effects as ZnAl₂O₄ etc., can be obtained. Although In is expensive as aforementioned, even if In is used in this case, when the amount of In may be only 10 wt% or less, the sputtering target does not become so expensive. By blending this calcination powder and ZnO powder, and performing the sintering process, densified zinc oxide ceramics can be obtained similarly. Since titanium (Ti) whichbelongs togroup IVA, silicon (Si), germanium (Ge), or tin (Sn) which belongs to group IVB, may be the dopant for n-type conductivity, and can be used similarly. In these cases, for production of the calcination powder, titanium dioxide (TiO₂) powder, silicon dioxide (SiO₂) powder, germanium-dioxide (GeO₂) powder, or tin oxide (IV) (SnO₂) powder is used respectively, instead of Al₂O₃ powder, and the main component of the obtained calcination powder is Zn₂TiO₄, Zn₂SiO₄, Zn₂GeO₄, and Zn₂SnO₄, respectively. Since these complex oxides also have spinel structure and have high melting point of 1000 °C or higher, similar effects as ZnAl₂O₄ can be obtained by using them. Here, Zinc oxide ceramics can be obtained by blending one of these calcination powders and ZnO powder, and by the sintering similarly. These zinc oxide ceramics can be used as the sputtering target for transparent electrodes formation, since these zinc oxide ceramics have low resistivity and are densified. Or, similar results are obtained by blending these complex oxide powders produced by some other methods without the calcination powder production process and ZnO powder, and by sintering them similarly. Or, it is also possible to use simultaneously two or more kinds of the oxide powder made of the aforementioned complex oxides containing the aforementioned dopants.

### (The 2nd embodiment)

In the zinc oxide ceramics concerning the 2nd embodiment, another element is also doped simultaneously in addition to the dopant in the zinc oxide ceramics conserning the 1st embodiment (for example, Al). Hereafter, the dopant used in the 1st embodiment (for example, Al) is called the 1st dopant, and another dopant used here is called the 2nd dopant. The 2nd dopant is used here to improve weather resistance, for example, heat resistance or moisture resistance of the ZnO electrodes. The 2nd dopants which bring these effects may be one or more kinds among Al, Ga, In, Ti, Si, Ge, and Sn, excepting the element used as the 1st dopant. Especially as the 2nd dopant, Ga or In is used preferably.

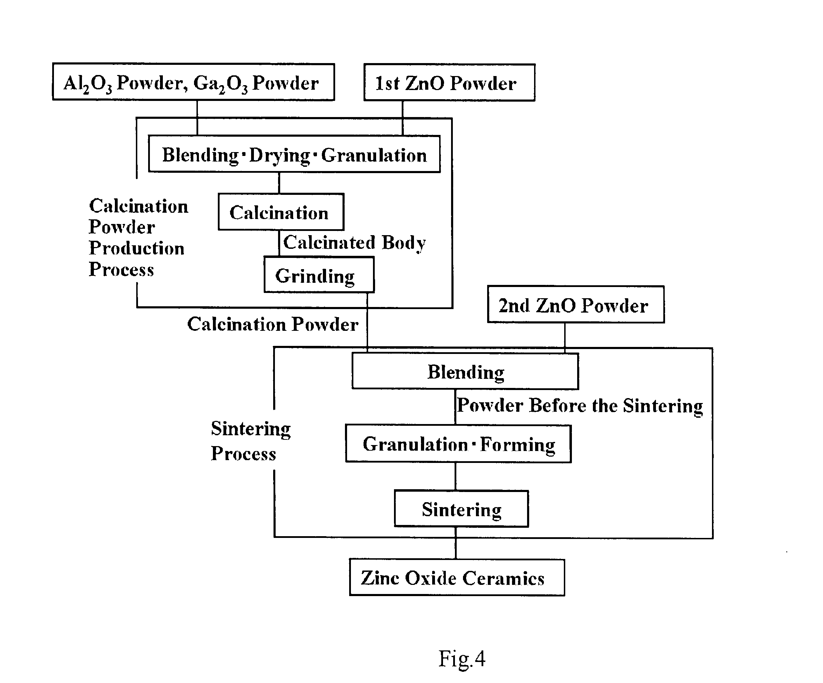

In the manufacturing method of zinc oxide ceramics concerning the 2nd embodiment when Al is selected as the 1st dopant and Ga is selected as the 2nd dopant, as shown in figure 4, both Al₂O₃ powder and Ga₂O₃ powder are blended with the 1st ZnO powder simultaneously, instead of Al₂O₃ powder in figure 1. Here, in the manufacturing method of zinc oxide ceramics of this embodiment, the ceramics are not obtained after blending Al₂O₃ powder and Ga₂O₃ powder and ZnO powder, forming, and sintering, but are obtained after producing the calcination powder containing both ZnAl₂O₄ phase and ZnGa₂O₄ phase, further blending the calcination powder and ZnO powder, forming, and sintering. Therefore, the calcinated body is obtained, after the 1st ZnO powder, Al₂O₃ powder, and Ga₂O₃ powder are blended, granulated, and calcinated in the air (calcination). Next, this calcinated body is ground again into powder with a predetermined particle diameter, and the calcination powder is produced. In this calcination powder, ZnAl₂O₄ which is a complex compound of ZnO and Al₂O₃, and ZnGa₂O₄ which is a complex compound of ZnO and Ga₂O₃, with spinel structure, are formed.

This calcination powder production process is carried to form ZnAl₂O₄ and ZnGa₂O₄ with spinel structure by solid-state reaction among Al₂O₃ powder made of α-alumina, β-alumina, or θ-alumina, and Ga₂O₃ powder made of α-Ga₂O₃ or β-Ga₂O₃, and ZnO powder made of ZnO with wurtzite structure. Therefore, the BET specific surface area of the 1st ZnO powder is preferred to be 2 ∼ 30m²/g. If it is smaller than 2m²/g, precipitates containing both ZnAl₂O₄ phase and ZnGa₂O₄ phase become large and cause the abnormal discharge. If it is larger than 30m²/g, ZnO particles will act as agglomerated particles and ZnO phase will not be distributed uniformly, and ZnAl₂O₄ phase etc., become large and cause the abnormal discharge. And the BET specific surface area of these oxide powders are preferred to be 2 ∼ 100m²/g. If it is smaller than 2m²/g, precipitates containing ZnAl₂O₄ phase etc., become large and cause the abnormal discharge. If it is larger than 100m²/g, Al₂O₃ particles etc., will act as agglomerated particles and ZnO phase will not be distributed uniformly, and ZnAl₂O₄ phase etc., become large and cause the abnormal discharge.

Another calcination conditions (calcination temperature, calcination time, atmosphere etc.) are basically same as the 1st embodiment.

In the calcinated body produced by the calcination, ZnAl₂O₄ and ZnGa₂O₄, these are complex oxides with spinel structure, are formed by solid-state reaction between ZnO and Al₂O₃, and by that between ZnO and Ga₂O₃. Therefore, molar ratio of the 1st ZnO powder to sum of the Al₂O₃ powder and the Ga₂O₃ powder is preferred to be 1:1, which is a stoichiometric composition. If this molar ratio becomes the oxide rich, residual Al₂O₃ phase etc., remains in the calcination powder. Then, in the sintering process later, ZnAl₂O₄ etc., is formed by solid-state reaction between this Al₂O₃ phase etc. , and the 2nd ZnO powder, and voids are formed simultaneously, and these voids will cause the abnormal discharge. On the other hand, if the ratio becomes ZnO rich, since the Al₂O₃ composition etc., in the calcination powder becomes small, sintering of ZnO itself progress during the calcination process and the degree of sintering after the sintering process becomes worse, then densified ceramics are hard to be obtained. Therefore, it is necessary to break the calcinated body into powder in this case. Therefore, this ratio is preferred to be ZnO:(Al₂O₃+Ga₂O₃) is 1:1 ∼ 200:1, and is preferred to be 1:1 ∼ 30:1 more. If the BET specific surface area of the calcination powder is less than 2m²/g, voids will be formed between ZnO particles and these voids will cause the abnormal discharge. If it is more than 30m²/g, these powders will agglomerate, and dispersibility will be worse, and the organization of the compound oxide phase in the ceramics will become nonuniform.

The BET specific surface area of the 2nd ZnO powder used in the sintering process is preferred also to be 2 ∼ 30m²/g. If it is less than 2m²/g, densified ceramics cannot be obtained in the sintering process. If it is more than 30m²/g, density of the formed body becomes low after the forming, therefore densified ceramics cannot be obtained in the sintering process either. This ZnO powder may become the main component of the zinc oxide ceramics obtained finally.

By setting the mixing ratio of the 2nd ZnO powder to the calcination powder in the sintering process, composition ratio of Al or Ga in the zinc oxide ceramics can be made 0. 5 - 10wt%, expressed as oxides. However, composition ratio of Al etc., in the calcination powder depends on the mixing ratio in the calcination powder production process. If the composition ratio of sum of Al and Ga in the zinc oxide ceramics is less than 0.5wt%, or is more than 10wt%, expressed as oxides, resistivity of the film formed by sputtering using said ceramics as the target will become high, 10⁻² Ω · cm or higher.

Another sintering conditions (the BET specific surface area of the calcination powder, mixing method of the calcination powder and the 2nd ZnO powder, the sintering temperature, the sintering atmosphere erc.) are basically similar to those of the 1st embodiment.

The calcination powder production process concerning the 2nd embodiment in figure 4 can be modified. In this case, the 1st calcinated body is formed by the 1st oxide powder made of oxide of the 1st dopant and by the 1st ZnO powder, and the 2nd calcinated body is formed by the 2nd oxide powder made of oxide of the 2nd dopant and by the 3rd ZnO powder. In this calcination powder production process, the 1st calcinated body and the 2nd calcinated body are ground into the calcination powder. This calcination powder and the 2nd ZnO powder are blended and formed, then the formed body is sintered in the sintering process.

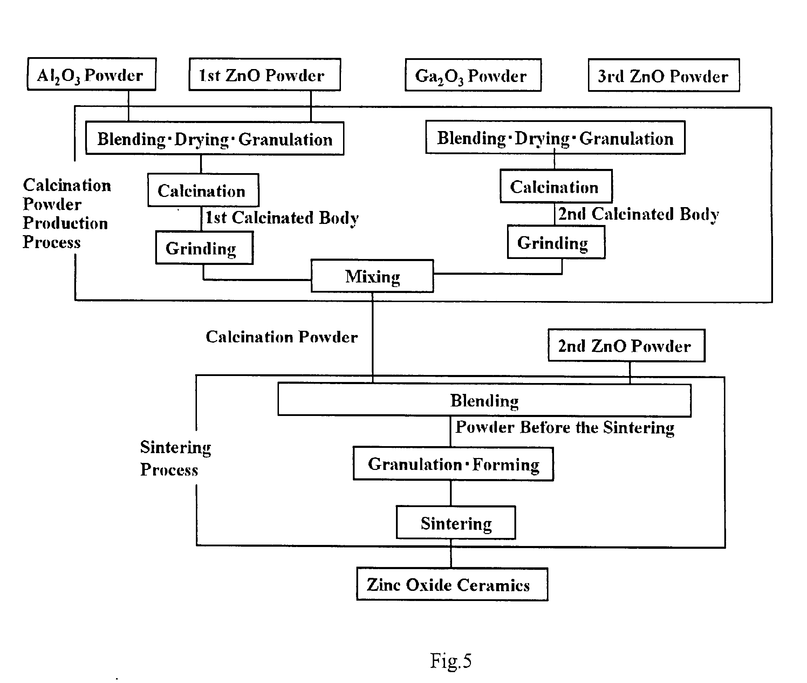

Figure 5 shows this manufacturing method. Here, Al is used as the 1st dopant and Ga is used as the 2nd dopant.

The 1st oxide powder (Al₂O₃) and the 1st ZnO powder are blended, dried, granulated, and by calcinating them, the 1st calcination powder is formed. Since this process is similar to the process by which the calcinated body is formed in the 1st embodiment (figure 1), that detailed description is omitted here. Therefore the 1st calcinated body contains ZnAl₂O₄ with spinel structure similarly.

Similarly, the 2nd oxide powder and the 3rd ZnO powder are blended, dried, granulated, and by calcinating them, the 2nd calcination powder is formed. This process is similar to the process by which the calcinated body is formed in the 1st embodiment (figure 1), except the 3rd ZnO powder is substituted for the 1st ZnO powder. Therefore the 2nd calcinatedbodycontains ZnGa₂O4 with spinel structure similarly.

Therefore, Ga₂O₃ powder used as the 2nd oxide powder is preferred to be α or β-Ga₂O₃, and, the BET specific surface area is preferred to be 2 ∼ 100m²/g. Especially α-Ga₂O₃ is preferred because ZnGa₂O₄ is easy to be formed. The purity is preferred to be 99.9% or higher.

The 3rd ZnO powder used here is used similarly to the 1st ZnO powder in the 1st embodiment. Therefore, the powder is preferred to be made of ZnO with wurtzite structure and the BET specific surface area is preferred to be 2 ∼ 30m²/g. The purity is preferred to be 99.9% or higher.

The 2nd oxide powder and the 3rd ZnO powder are blended, mixed with a ball mill, granulated, then calcinated at the temperature of 900 ∼ 1300 °C (calcination), and the 2nd calcinated body is produced.

The atmosphere of the calcination is preferred to be non-reducing atmosphere, especially is preferred to be the air or oxygen atmosphere. In the 2nd calcinated body, complex oxide ZnGa₂O₄ with spinel structure is formed by solid-state reaction between ZnO particles and Ga₂O₃ particles. The calcination temperature is preferred to be 1 to 5 hours.

In the 1st calcinated body and in the 2nd calcinated body, particles are bonded by the calcination. This calcinated body is ground by some mechanical processes, such as a ball mill process, and the particle size(particle diameter) is made to a desired size, and the calcination powder is obtained. Or, the 1st calcination powder may be formed by the 1st calcinated body, and the 2nd calcination powder may be formed by the 2nd calcinated body, and the calcination powder may be produced by mixing these powders.

The BET specific surface area of the calcination powder is preferred to be 2 ∼ 30m²/g. The state of the 1st calcinated body or the 2nd calcinated body depends on the mixture ratio (the 1st ZnO powder / the 1st oxide powder) or (the 3rd ZnO powder / the 2nd oxide powder), respectively. If this ratio is large, ZnO phase is formed more and ZnO particles becomes large by grain growth of ZnO phase after the calcination. Therefore, adjusting of the particle size is necessary to set the BET specific surface area in the above-mentioned range.

Therefore, in producing the 1st and the 2nd calcination powder, mixing molar ratios (the 1st ZnO powder / the 1st oxide powder (Al₂O₂)), (the 3rd ZnO powder / the 2nd oxide powder (Ga₂O₃)), is preferred to be 1 ∼ 200, and is preferred to be 1 ∼ 30 especially. And the mixing molar ratio of sum of the 1st ZnO powder and the 3rd ZnO powder to sum of the 1st oxide powder and the 2nd oxide powder, is preferred to be 1 ∼ 200, and is preferred to be 1-30 especially.

Here, ZnAl₂O₄ phase and ZnGa₂O₄ phase coexist in the calcination powder concerning this embodiment. In the sintering process, this calcination powder and the 2nd ZnO powder are blended, granulated, formed, and sintered, and zinc oxide ceramics are obtained similarly as the 1st embodiment.

The sintering process is similar to that of the 1st embodiment. Here, in the sintering process, zinc oxide ceramics are obtained by sintering the formed body at the temperature of 1100 ∼ 1600 °C. The sintering time is preferred to be 1 to 5 hours.

When doping Ga or In as the 2nd dopant which improves weather resistance, composition ratio of sum of Al and Ga or In in the zinc oxide ceramics is preferred to be 0.05 - 10wt%, expressed as oxides, because of similar reasons as mentioned above. In these dopants, composition ratio of Ga or In is preferred to be 0.05 - 5wt%, expressed as oxides. If the composition ratio of Ga or In in zinc oxide ceramics is less than 0.05wt% expressed as oxide, enough weather resistance cannot be obtained in the transparent electrodes formed using the sputtering target made of these ceramics. And reisitivity is not low enough when the composition ratio is greater than 5wt%. Neither the reisitivity is not low enough, when the composition ratio of sum of Al and Ga or In is greater than 10wt%.

When producing the calcination powder by blending the 1st ZnO powder and Al₂O₃ powder and Ga₂O₃ powder simultaneously, mixing molar ratio of sum of the Al₂O₃ powder and the Ga₂O₃ powder to the 1st ZnO powder, is preferred to be 1:1, which is the stoichiometric composition. Or, ratio of ZnO : (Al₂O₃ + Ga₂O₃) is preferred to be 1:1 ∼ 200:1, and is preferred to be 1:1 ∼ 30:1 especially.

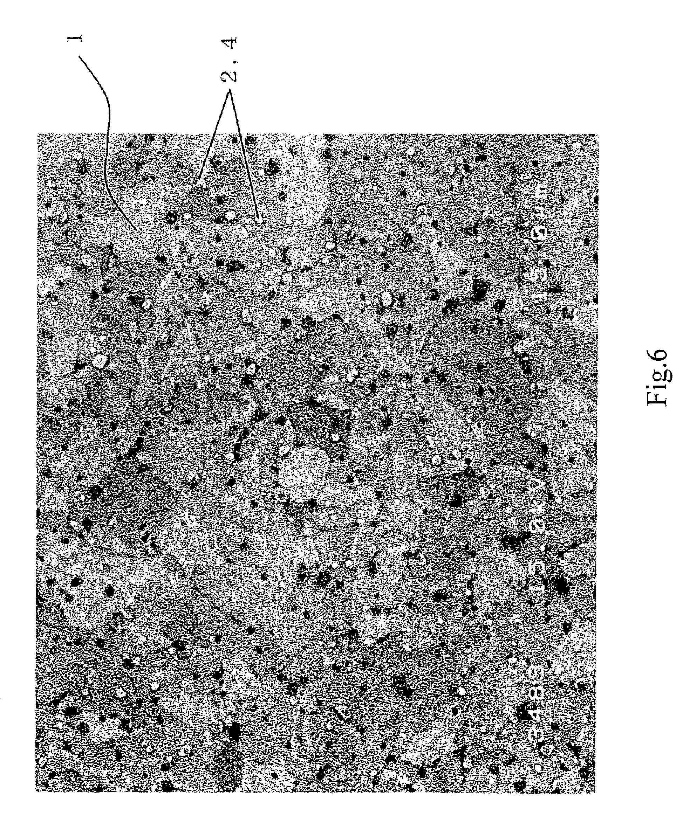

AZO ceramics in which ZnO powder (wurtzite structure, the BET specific surface area = 5m²/g), Al₂O₃ powder (α-alumina, the BET specific surface area =11m²/g), and Ga₂O₃ powder (α-Ga₂O₃, the BET specific surface area = 3m²/g) are contained with the weight ratio of 97.5:2.0:0.5 were produced by the manufacturing method of this embodiment. The sintering temperature was 1400 °C. A SEM photograph of the mirror polished cross section of the ceramics is shown in figure 6. In figure 6, portion 1, 2 corresponds to ZnO phase, ZnAl₂O₄ phase, respectively, similarly to those shown in figure 2, 3, and portion 4 corresponds to ZnGa₂O₄ phase with spinel structure. Then, similarly to the case in figure 3, voids were not seen around ZnAl₂O₄ phase 2 or around ZnGa₂O₄ phase 4, and the density of these ceramics was 5.6g/cm³. Further, on precipitates made of ZnAl₂O₄ phase 2 or of ZnGa₂O₄ phase 4, it was found that ratio of the large precipitates to all precipitates became small.

Therefore, since the abnormal discharge is suppressed also by using these zinc oxide ceramics for the sputtering target, transparent electrodes with high conductivity can be formed.

Furthermore, both the 2nd dopant which improve the weather resistance(heat resistance, moisture resistance) and the 1st dopant which is a conductive dopant, are doped in this zinc oxide ceramics simultaneously. Therefore, transparent electrodes with both high weather resistance and high conductivity can be formed, by using these zinc oxide ceramics for the sputtering target.

### (The 3rd embodiment)

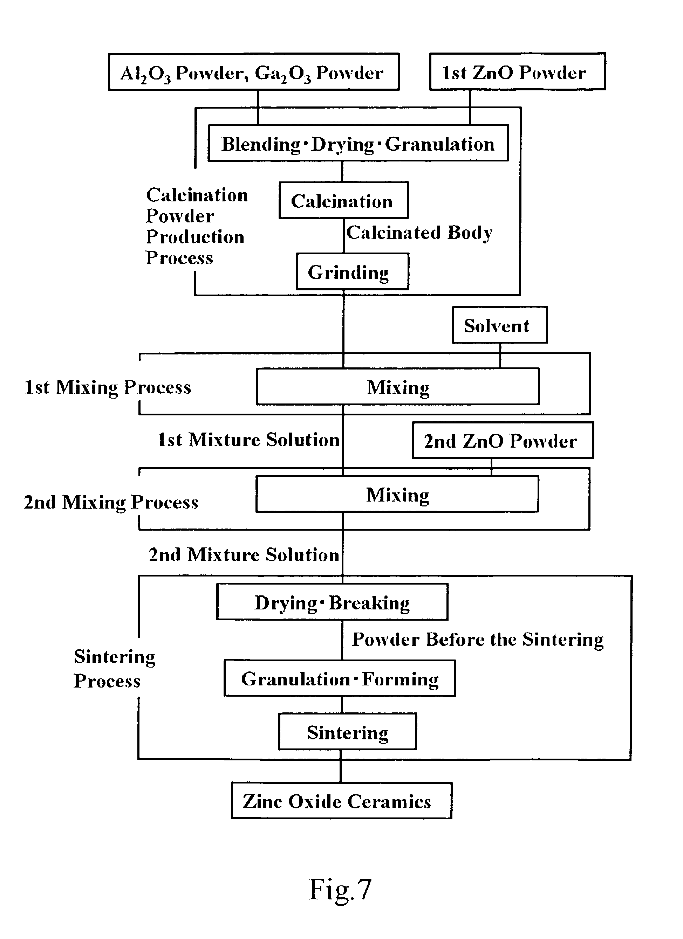

Similar zinc oxide ceramics can also be obtained by another manufacturing method concerning the 3rd embodiment instead of by the manufacturing method of the 1st or the 2nd embodiment. This example is shown in figure 7. By this manufacturing method, the dispersibility of the 1st dopant and the 2nd dopant in the zinc oxide ceramics can be improved further, and the abnormal discharge can be suppressed further.

Here, the calcination powder produced by the calcination powder production process similar to that of the 2nd embodiment (figure 4) is dissolved in a solvent, mixed by ball mill etc., and the 1st mixture solution is produced (1st mixing process). The 2nd ZnO powder is dissolved in the 1st mixture solution, they are mixed with a ball mill etc. , and the 2nd mixture solution is produced (2nd mixing process). In the sintering process, this 2nd mixing solution is dried and broken into powder and the powder before the sintering is produced, by adjusting the particle size of the powder. The powder before the sintering is granulated, molded similarly to the 1st embodiment, and zinc oxide ceramics are obtained after the sintering the molded body.

In this manufacturing method, since mixture of the calcination powder is made in the solution, agglomeration in the calcination powder can be suppressed. Therefore, the dispersibility of the calcination powder in the 2nd ZnO powder can be improved. Therefore, the dispersibility of ZnAl₂O₄ phase or ZnGa₂O₄ phase in the ceramics which is produced by sintering the molded body made of the powder before the sintering which is produced from the 2nd mixture solution, is improved.

As the solvent used in the 1st mixing process or in the 2nd mixing process of this production method, pure water or ethanol can be used, for example. And, mixture in the 1st mixing process or the 2nd mixing process may be done using a beads mill.

When Al is used as the 1st dopant and Ga is used as the 2nd dopant, the ceramics with high dispersibility of ZnAl₂O₄ phase and of ZnGa₂O₄ phase can be obtained, by producing the calcination powder by blending the Al₂O₃ powder and Ga₂O₃ powder with ZnO powder in the calcination powder production process, and by using this calcination powder in the 1st mixing process and in the 2nd mixing process similarly to above. Here, the ZnO powder in this calcination powder production process serves as the 1st ZnO powder and also the 3rd ZnO powder.

By aforementioned manufacturing method, in the ZnO phase which is the main phase in the ceramics, co-precipitation part in which precipitate containing ZnAl₂O₄ phase (the 1st precipitate) and precipitate containing ZnGa₂O₄ phase (the 2nd precipitate) coexist, is formed. Here, this co-precipitation part may contain ZnO phase or ZnO phase in which dopant such as Al or Ga is dissolved, and it contain complex oxide phases, ZnAl₂O₄ phase and ZnGa₂O₄ phase, these are formed adjoining to each other. Here, the state in which ZnAl₂O₄ phase and ZnGa₂O₄ phase coexist in this co-precipitation part, is controlled by making agglomerated body or condensed body of the particle, or by adjusting doping amount of dopants or some other manufacturing parameters.

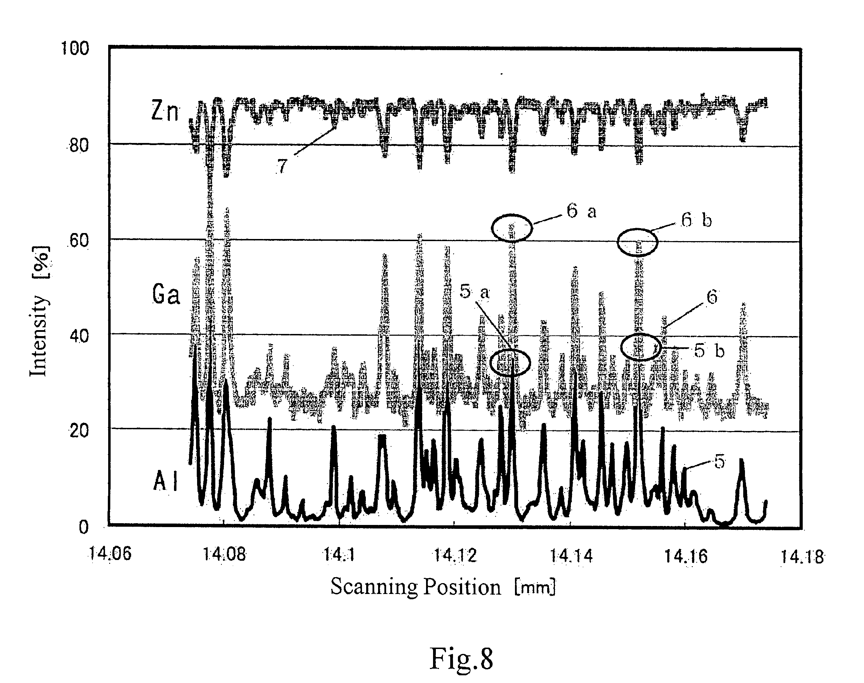

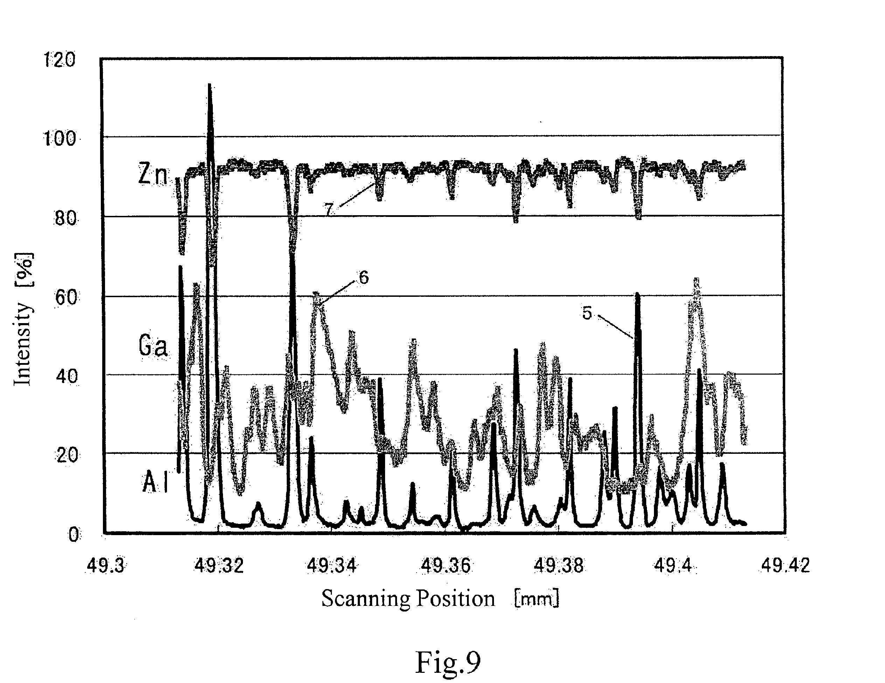

AZO ceramics in which ZnO powder (wurtzite structure, the BET specific surface area = 5m²/g), Al₂O₃ powder (α-alumina, the BET specific surface area = 11m²/g), and Ga₂O₃ powder (α-Ga₂O₃, the BET specific surface area = 3m²/g) are contained with the weight ratio of 97.5:2.0:0.5 were manufactured by the manufacturing method shown in figure 7. The sintering temperature was 1400 °C. Result of EPMA(Electron Probe Micro Analysis) of the mirror polished cross section of the ceramics is shown in figure 8. Also result of EPMA of the ceramics manufactured by the manufacturing method of the 2nd embodiment without the 1st mixing process and the 2nd mixing process, is shown in figure 9 for comparison. Here, acceleration voltage of SEM is 20kV, sample current is 50nA, and used beam diameter is 1µm, in this analysis. In figures 8 and 9, horizontal axis corresponds to the position of the scanning electron beam of EPMA on the ceramics. The vertical axis corresponds to the intensity of the characteristic X-ray of an applicable element, and corresponds to the abundance of an element. In figures 8 and 9, a solid line expressed as 5 shows Al content in the ceramics, a solid line expressed as 6 shows Ga content, and a solid line expressed as 7 shows Zn content. Here, intensity of characteristic X-ray of each element is shown as relative value in figure 8, the intensity corresponding to 100% composition of Al, Ga, Zn is 20000, 1500, 40000, respectively. And, the intensity corresponding to 100% composition of Al, Ga, Zn is 20000, 2000, 40000, respectively in figure 9.

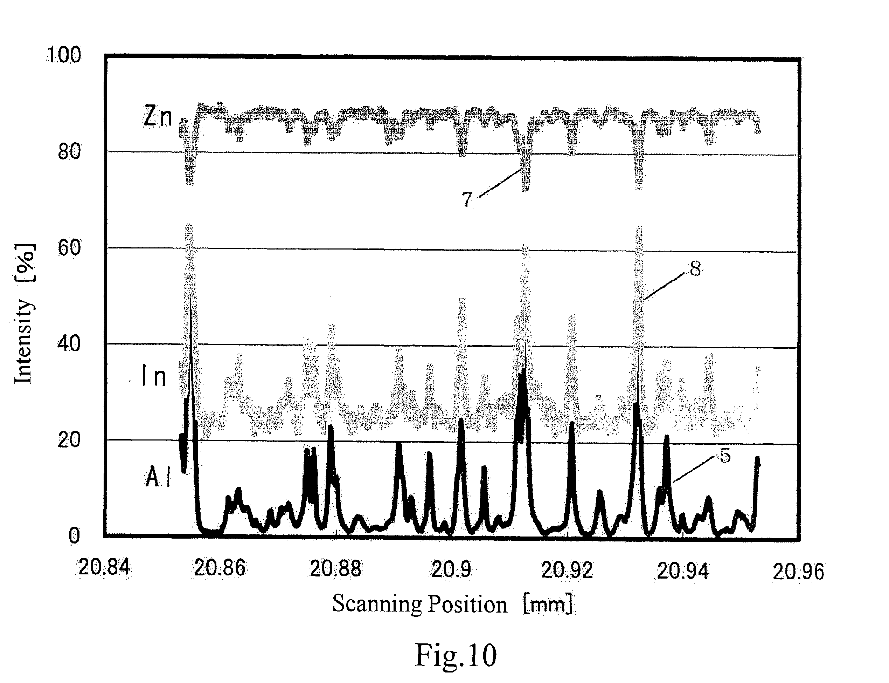

Result of EPMA(Electron Probe Micro Analysis) of the mirror polished cross section of the ceramics produced by the manufacturing method shown in figure 7, in which In is doped as the 2nd dopant instead of Ga, or In₂O₃ powder (the BET specific surface area = 6m²/g) is used instead of above-mentioned Ga₂O₃ powder, is shown in figure 10. In figure 10, a solid line expressed as 5 shows Al content in the ceramics, a solid line expressed as 8 shows In content. Here, intensity of characteristic X-ray of each element is shown as relative value also in figure 10, the intensity corresponding to 100% composition of Al, In, Zn is 20000, 1500, 40000, respectively.

In figures 8 ∼ 10, each local maximum of data shown in the solid line expressed as 5, 6, 8 corresponds to the precipitate made of compound containing Al, Ga, In, respectively (namely, ZnAl₂O₄, ZnGa₂O₄, ZnIn₂O₄, respectively). In figure 8, variation in the solid line 5 showing ZnAl₂O₄ phase and that in the solid line 6 showing ZnGa₂O₄ phase are almost equivalent. Especially, position of local maximums (for example, 5a, 5b) of solid line 5 and position of local maximums (for example, 6a, 6b) of solid line 6 are almost equal. Therefore, it is found that ZnAl₂O₄ phase and ZnGa₂O₄ phase coexist in almost same portion in the ceramics. From figure 10, it is also found that ZnAl₂O₄ phase and ZnIn₂O₄ phase coexist in almost same portion in the ceramics when In₂O₃ powder is used instead of Ga₂O₃.

On the other hand, in the ceramics manufactured by manufacturing method not using both the 1st mixing process and the 2nd mixing process, variation of solid line 5 and that of solid line 6 differ. Positions of local maximum in these lines are different. Therefore, in the ceramics manufactured by the manufacturing method using both the 1st mixing process and the 2nd mixing process, co-precipitation part in which ZnAl₂O₄ phase and ZnGa₂O₄ phase or ZnIn₂O₄ phase coexist, is formed.

Here, since sputtering rate depends on material composition, sputtering rate varies according to the precipitate phase in the ceramics. Then, if many kinds of compound phase are seen in the ceramics, because a phase may be easy to be sputtered and another phase may be harder to be sputtered than it, a nodule will be easily formed in the ceramics. In this invention, by making these different phases with different sputtering rate coexist in the co-precipitation part, amount of part with different sputtering rate in the ceramics may be decreased, and the nodule is hard to be formed. Therefore, when the ceramics in which aforementioned co-precipitation parts were formed are used as the sputtering target, selective erosion of ZnGa₂O₃ phase compared to that of ZnAl₂O₄ phase can be suppressed especially. Therefore, the abnormal discharge caused by the erosion of ZnGa₂O₄ phase is suppressed further.

By this manufacturing method, co-precipitation parts in which volume ratio of ZnGa₂O₄ phase or ZnIn₂O₄ phase (the 2nd precipitate) to ZnAl₂O₄ phase (the 1st precipitate) is made 1 ∼ 50 %, can be formed.

Here, the ratio of ZnGa₂O₄ phase etc., to ZnAl₂O₄ phase was measured by EPMA analysis. For example, the co-precipitation parts in which ZnAl₂O₄ phase and ZnGa₂O₄ phase coexist correspond to parts in which both local maximum of solid line 5 and local maximum of solid line 6 are seen simultaneously in figure 7, as explained before. And, intensity at local maximum 5a of solid line 5 is proportional to content of ZnAl₂O₄ phase at that position, and intensity at local maximum 6a of solid line 6 is proportional to content of ZnGa₂O₄ phase at that position. Therefore, by calculating ratio of the intensity at local maximum 6a to the intensity at local maximum 5a, the ratio of ZnGa₂O₄ phase to ZnAl₂O₄ phase (ZnGa₂O₄ phase / ZnAl₂O₄ phase) in the co-precipitation part can be known. In other co-precipitation parts, the ratio of ZnGa₂O₄ phase to ZnAl₂O₄ phase can be measured similarly.

The volume ratio of the co-precipitation parts in which diameter of equivalent circle is 10µm or larger, to all co-precipitation parts, can be made 90% or more, by this manufacturing method. If this ratio becomes less than 90%, co-precipitation parts comprising both ZnGa₂O₄ phase and ZnAl₂O₄ phase with different resistivity are distributed in ZnO phase nonuniformly and locally, then these co-precipitation parts may cause the abnormal discharge.

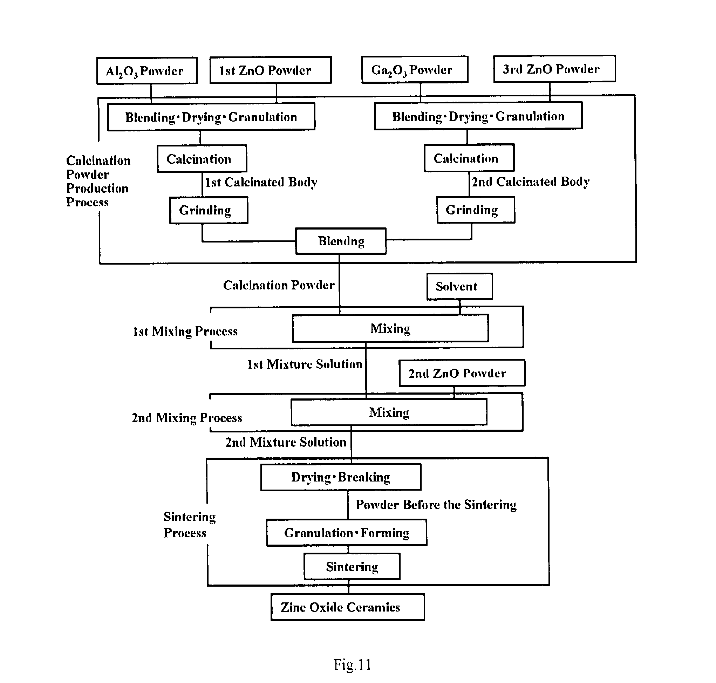

When producing the 1st calcination powder containing ZnAl₂O₄ phase using Al₂O₃ powder and the 2nd calcination powder containing ZnGa₂O₄ phase using Ga₂O₃ powder, the 1st mixture solution may be produced by mixing a solution in which the 1st calcination powder is mixed with the solvent, and another solution in which the 2nd calcination powder is mixed with the solvent, in the 1st mixing process, as shown in figure 11. In this case, since each mixing process can be performed using optimal condition for each calcination powder, the dispersibility of the calcination powder can be improved further in the 2nd ZnO powder.

By producing the 2ndmixture solution in the 2ndmixing process, in which the 1st mixture solution is mixed with a solution in which the 2nd ZnO powder is mixed with the solvent, agglomeration of the 2nd ZnO powder in the 2nd mixture solution is suppressed, and rough and large ZnO phase in the caramics is hard to be formed, therefore, it is more preferred.

Therefore, according to the manufacturing method concerning the 3rd embodiment, the abnormal discharge is further suppressed using the zinc oxide ceramics for the sputtering target. Therefore, transparent electrodes with high conductivity can be obtained repeatedly, especially.

This manufacturing method can be applied also to the 1st embodiment in which only Al₂O₃ or Ga₂O₃ is doped, for example.

Here, in aforementioned 2nd and 3rd embodiments, Ga or In is used as the doping element which improves weather resistance (the 2nd dopant), although also other elements can be used as the 2nd dopant. Titanium (Ti), silicon (Si), germanium (Ge), or tin (Sn) may be used as that. For example, when Ti is selected, titanium dioxide (TiO₂) powder is used for production of calcination powder instead of Ga₂O₃ powder, and the complex oxides used as the main components of the calcination powder obtained using this is ZnAl₂O₄ and ZnTiO₄. Zinc oxide ceramics can be obtained by blending this calcination powder and ZnO powder, and by the sintering. When selecting Si, Ge, or Sn for production of the calcination powder, silicon dioxide (SiO₂) powder, germanium-dioxide (GeO₂) powder, or tin oxide (SnO₂) powder is used instead of Ga₂O₃ powder respectively, and obtained complex oxide which is the main component of the obtained calcinated body contains Zn₂SiO₄, Zn₂GeO₄, or Zn₂SnO₄ respectively. Therefore, the zinc oxide ceramics can be obtained by mixing one or more of these calcination powders and ZnO powder and by the sintering. Transparent electrodes with improved weather resistance can be obtained with suppressed abnormal discharge using this zinc oxide ceramics for the sputtering target. It is also possible to use simultaneously two or more kinds of the oxide powder as conductive dopants, or two or more complex oxide powder. Although Ga, In, Ti, Si, Ge, or Sn is used also as the 1st dopant, the 2nd dopant here means the element which is not equal to the 1st dopant.

### [Example]

Hereafter, the examples of this invention are described. However, this invention is not limited by these examples.

At first, the examples concerning the 1st embodiment are described. In the zinc oxide ceramics of examples 1 ∼ 28 and comparative examples 1 ∼ 14 described below, the 1st ZnO powder and the oxide powder with predetermined BET specific surface area were blended with predetermined mixing weight ratios, and were mixed with the ball mill for 20 hours, dried later, and mixed powders were obtained. These mixed powders were caicinated in the air at predetermined temperatures for 2 hours, and the calcinated bodies were obtained. On these calcinated bodies, mixing by the ball mill as shown before was done similarly, and the calcination powders with predetermined BET specific surface area were obtained. After blending the calcination powders and the 2nd ZnO powders with predetermined BET specific surface area with shown ratios such that the oxide compositions of the ceramics are set as predetermined, mixing them by the ball mill for 20 hours, drying, and the powders before the sintering were obtained. After mixing polyvinyl alcohols with the powders before the sintering by 1wt%, granulating, forming were done by uniaxial pressing with pressure of 1 ton/cm² at first and by CIP with pressure of 3 ton later, and the formed bodies of ϕ180mm × 7mm were obtained. After dewaxing the formed body in the air at 600°C for 1 hour, the sinterings were done at predetermined temperature in the air for 2 hours, and the zinc oxide ceramics were obtained. The BET specific surface area of each of aforementioned powders were measured by the BET specific surface area measuring instrument (Macsorb (model 1201): made by Mountech Corp., Japan).

After setting the zinc oxide ceramics as the sputtering targets in sputtering apparatus, zinc oxide thin films were formed on the Corning #1737 glass substrates by sputtering (sputtering type:DC magnetron, sputtering gas:Ar, gas pressure:0.5Pa, magnetic flux density:1000Gauss, time:1 hour), and the discharge characteristics while the sputterings were investigated. If the abnormal discharge arose more than twice during the sputterings, it was judged as no good (NG). And by taking SEM photograph of mirror polished cross section of each sample, numbers of precipitates and voids in unit surface area were counted, shape and area of each of them were measured too. On the precipitates and the voids seen here, the diameters of equivalent circle were computed from the areas of them, and ratios of them whose diameters of equivalent circles (to total number of precipitates or voids) are 3µm or larger were computed. The densities of the ceramics were measured by weight-in-air / water method.

### (Examples 1 ∼ 4, comparative examples 1 and 2)

In Examples 1 ∼ 4 and comparative examples 1 and 2, α -alumina (Al₂O₃) was used as the oxide, and the effects of the calcination temperature on AZO ceramics were investigated. Here, the BET specific surface area of the 1st ZnO powder or the oxide powder was set to 5m²/g or 11m²/g, respectively, and the molar ratio (the 1st ZnO powder / the Al₂O₃ powder) was set to 1. Both the BET specific surfaces area of the 2nd ZnO powder and the powder before the sintering were set to 5m²/g, and the weight ratio of the oxide in the powder before the sintering was set to 2%. The sintering temperature was 1500°C and the calcination temperature was in the range of 800 ∼ 1400°C.

The aforementioned measurement results on the ceramics of examples 1 ∼ 4 and comparative examples 1 and 2 are shown in Table 1. Excellent discharge characteristics were obtained in examples 1 ∼ 4 with the calcination temperature of 900 ∼ 1300 °C, and the abnormal discharge occurred in comparative examples 1 and 2 with the calcination temperature out of the range.

[Table 1]

**Table.1**

| | | Calcination Temperature (°C) | Calcination Powder BET(m²/g) | Ceramics density (g/cm³) | ≧3µm Precipitates (%) | ≧3µm Voids (%) | Discharge Characteristics |
|---|---|---|---|---|---|---|---|
| Example | 1 | 950 | 5 | 5.6 | 10 | 15 | Good |
| | 2 | 1000 | 8 | 5.6 | 5 | 5 | Good |
| | 3 | 1200 | 3 | 5.6 | 12 | 21 | Good |
| | 4 | 1300 | 2 | 5.6 | 16 | 25 | Good |
| Comparative Example | 1 | 800 | 1 | 5.1 | 25 | 76 | NG |
| | 2 | 1400 | 0.5 | 5.3 | 36 | 64 | NG |

### (Examples 5 ∼ 9, comparative examples 3 and 4)

In examples 5 ∼ 9 and comparative examples 3 and 4, similar powders as the aforementioned examples 1 ∼ 4 were used, and effects of the sintering temperature on the characteristics of AZO ceramics were investigated. The calcination temperature was 1000°C and the sintering temperature was in the range of 1000 ∼ 1700°C. Other conditions are similar to those in aforementioned examples 1 ∼ 4.

The aforementioned measurement results on the ceramics of examples 5 ∼ 9 and comparative examples 3 and 4 are shown in Table 2. Excellent discharge characteristics were obtained in examples 5 ∼ 9 with the sintering temperature of 1100 ∼ 1600 °C, and the abnormal discharge occurred in comparative examples 3 and 4 with the sintering temperature out of the range.

[Table 2]

**Table.2**

| | | Sintering Temperature (°C) | Ceramics density (g/cm³) | ≧ 3µm Precipitates (%) | ≧3µm Voids (%) | Discharge Characteristics |
|---|---|---|---|---|---|---|
| Example | 5 | 1100 | 5.6 | 8 | 44 | Good |
| | 6 | 1200 | 5.6 | 10 | 26 | Good |
| | 7 | 1400 | 5.6 | 10 | 15 | Good |
| | 8 | 1500 | 5.6 | 5 | 5 | Good |
| | 9 | 1550 | 5.6 | 12 | 22 | Good |
| Comparative Example | 3 | 1000 | 5.4 | 8 | 71 | NG |
| | 4 | 1700 | 5.3 | 33 | 68 | NG |

### (Examples 10 ∼ 15, comparative examples 5 ∼ 7)

In examples 10 ∼ 15 and comparative examples 5 ∼ 7, similar powders as the aforementioned examples 1 ∼ 9 were used, and effects of mixing molar ratio, the 1st ZnO power / Al₂O₃ powder, on the characteristics of AZO ceramics were investigated. The calcination temperature was 1000°C and the sintering temperature was 1500 °C. The mixing molar ratio, i.e, the 1st ZnO powder / the Al₂O₃ powder, was in the range of 0.2 ∼ 210. The weight ratio of the oxide in the powder before the sintering was 0.5 or 2wt%. Other conditions are similar to the aforementioned examples 1 ∼ 4.

The aforementioned measurement results on the ceramics of examples 10 ∼ 15 and comparative examples 5 ∼ 7 are shown in Table 3. Excellent discharge characteristics were obtained in examples 10 ∼ 15 with the mixing molar ratio of 1.0 ∼ 200, and the abnormal discharge occurred in comparative examples 5 ∼ 7 with the molar ratio out of the range. Further, when the molar ratio is in the range of 1.0 ∼ 30, the ratio of the precipitates or the voids whose diameters of equivalent circles are 3 µm or larger becomes small.

[Table 3]

**Table.3**

| | | 1st ZnO / Al₂O₃ Ratio | Calcination Powder BET (m²/g) | Oxide Ratio in the Powder Before the Sintering (wt%) | Ceramics Density (g/cm³) | ≧3µm Precipitates (%) | ≧3µm Voids (%) | Discharge Characteristics |
|---|---|---|---|---|---|---|---|---|
| Example | 10 | 1 | 6 | 2 | 5.6 | 5 | 5 | Good |
| | 11 | 10 | 5 | 2 | 5.6 | 2 | 4 | Good |
| | 12 | 20 | 5 | 2 | 5.6 | 5 | 8 | Good |
| | 13 | 60 | 4 | 2 | 5.8 | 9 | 11 | Good |
| | 14 | 120 | 4 | 0.5 | 5.6 | 9 | 20 | Good |
| | 15 | 190 | 4 | 0.5 | 5.6 | 15 | 40 | Good |
| Comparative Example | 5 | 0.2 | 3 | 2 | 4.8 | 37 | 82 | NG |
| | 6 | 0.5 | 4 | 2 | 5.1 | 25 | 55 | NG |
| | 7 | 210 | 4 | 2 | 5.4 | 28 | 55 | NG |

### (Examples 16 ∼ 18, comparative examples 8 and 9)

In examples 16 ∼ 18 and comparative examples 8 and 9, similar powders as the aforementioned examples 1 ∼ 15 were used, and effects of the BET specific surface area of the powder before the sintering, on the characteristics of AZO ceramics were investigated. The calcination temperature was 1000°C and the sintering temperature was in the range of 1400 ∼ 1500°C. The BET specific surface area of the powder before the sintering was in the range of 0.5-21m²/g. Other conditions are similar to the aforementioned examples 1 ∼ 4.

The aforementioned measurement results on the ceramics of examples 16 ∼ 18 and comparative examples 8 and 9 are shown in Table 4. Excellent discharge characteristics were obtained in examples 16 ∼ 18 with the BET specific surface area of 1 ∼ 20m²/g, and the abnormal discharge occurred in comparative examples 8 and 9 with the BET specific surface area out of the range.

[Table 4]

**Table.4**

| | | Powder Before the Sintering BET(m²/g) | Sintering Temperature (°C) | Ceramics Density (g/cm³) | ≧3µm Precipitates (%) | ≧3µm Voids (%) | Discharge Characteristics |
|---|---|---|---|---|---|---|---|
| Example | 16 | 4 | 1550 | 5.6 | 12 | 22 | Good |
| | 17 | 5 | 1500 | 5.6 | 5 | 5 | Good |
| | 18 | 14 | 1400 | 5.6 | 5 | 6 | Good |
| Comparative Example | 8 | 0.5 | 1500 | 4.8 | 23 | 67 | NG |
| | 9 | 21 | 1500 | 5.4 | 15 | 59 | NG |

### (Examples 19 ∼ 28, comparative examples 10 ∼ 14)

In examples 19 ∼ 28 and comparative examples 10 ∼ 14, parameters were varied out of the range of aforementioned examples or comparative examples, and the characteristics of the ceramics obtained eventually were investigated. In examples 19 ∼ 21, the BET specific surface area of the 1st ZnO powder was varied in the range of 5 ∼ 20 m²/g, the mixing molar ratio of the 1st ZnO / Al₂O₃ was varied in the range of 1 ∼ 100, dopant concentration of the ceramics was varied in the range of 2 ∼ 4 %, and the sintering temperature was varied in the range of 1300 ∼ 1500°C. In examples 22 and 23, the BET specific surface area of the oxide (Al₂O₃) powder was 4m²/g, 59m²/g respectively, and that of the calcination powder was 5m²/g, 22m²/g respectively. In example 24, 0.5 weight % of the oxide powder (Al₂O₃) was replaced by TiO₂, and the oxide powder was Ga₂O₃ (100%) in example 25. In example 26, the calcination temperature was 900°C, the BET specific surface area of the calcination powder was 25m²/g, and the sinteringn temperature was 1100°C. In example 27, the calcination temperature was 1300°C, the sintering temperature was 1100°C, therefore the calcination temperature was made higher than the sintering temperature. In example 28, dopant concentration during the sintering was made as small as 0.5%.

In comparative example 10, the BET specific surface area of the 1st ZnO powder, the calcination powder, or the powder before the sintering was made as small as 1m²/g, 0.5m²/g, or 0.8m²/g, respectively. In comparative example 11, the BET specific surface area of the oxide powder (Al₂O₃), the calcination powder, or the powder before the sintering was made as small as 1m²/g, 0.5m²/g, or 0.8m²/g, respectively. In comparative example 12, the oxide powder was made of Ga₂O₃, and the weight ratio of the 1st ZnO / the oxide was as small as 0.5. In comparative example 13, the BET specific surface areas of both the oxide powder and the calcination powder were made as small as 1m²/g. In comparative example 14, the molar ratio of the 1st ZnO powder / the oxide powder was as large as 220.

The aforementioned measurement results on the ceramics of examples 19 ∼ 28 and comparative examples 10 ∼ 14 are shown in Table 5. Excellent discharge characteristics were obtained in examples 19 ∼ 28, and the abnormal discharge occurred in comparative examples 10 ∼ 14. In the example 27 in which the sintering temperature was lower than the calcination temperature, although the excellent discharge characteristic was obtained, the ratio of voids with large size became larger than other examples. Therefore, it turns out that the sintering temperature is preferred to be higher than the calcination temperature.

[Table 5]

**Table 5**

| | | Oxide Powder | 1st ZnO Powder BET | Oxide Powder BET | ZnO/Oxide Weight Ratio | Calcination Temperature (°C) | Calcination Powder BET | 2nd ZnO Powder BET | Powder Before the Sintering BET | Dopant Concentration (the Sintering) | Sintering Temperature | Ceramics Density | ≧3µm Precipitates | ≧3µm Voids | Discharge Characteristic |
|---|---|---|---|---|---|---|---|---|---|---|---|---|---|---|---|
| | | | (m²/g) | (m²/g) | | | (m²/g) | (m²/g) | (m²/g) | (wt%) | (°C) | (g/cm²) | (%) | (%) | |
| Examples | 19 | Al₂O₃ | 5 | 11 | 1 | 1000 | 8 | 5 | 5 | 2 | 1500 | 5.6 | 5 | 5 | Good |
| | 20 | Al₂O₃ | 10 | 11 | 10 | 1000 | 10 | 10 | 6 | 2 | 1350 | 5.6 | 5 | 8 | Good |
| | 21 | Al₂O₃ | 20 | 11 | 100 | 1000 | 7 | 10 | 8 | 4 | 1300 | 5.6 | 9 | 11 | Good |
| | 22 | Al₂O₃ | 5 | 4 | 1 | 950 | 5 | 5 | 5 | 2 | 1400 | 5.6 | 10 | 15 | Good |
| | 23 | Al₂O₃ | 5 | 59 | 1 | 950 | 22 | 5 | 14 | 2 | 1400 | 5.6 | 2 | 2 | Good |
| | 24 | Al₂O₃ TiO₂(0.5wt%) | 5 | 11 | 1 | 1000 | 8 | 5 | 5 | 2.5 | 1400 | 5.6 | 10 | 6 | Good |
| | 25 | Ga₂O₃ | 5 | 3 | 1 | 1000 | 4 | 5 | 5 | 9 | 1300 | 5.8 | 18 | 12 | Good |
| | 26 | Al₂O₃ | 5 | 11 | 1 | 900 | 25 | 5 | 5 | 2 | 1100 | 5.6 | 5 | 12 | Good |
| | 27 | Al₂O₃ | 5 | 11 | 1 | 1300 | 3 | 5 | 5 | 2 | 1100 | 5.6 | 14 | 38 | Good |
| | 28 | Al₂O₃ | 5 | 11 | 1 | 1000 | 3 | 5 | 5 | 0.5 | 1500 | 5.6 | 4 | 9 | Good |
| Comparative Example | 10 | Al₂O₃ | 1 | 11 | 1 | 1000 | 0.5 | 5 | 0.8 | 2 | 1600 | 4.8 | 42 | 82 | NG |
| | | Al₂O₃ | 5 | 1 | 1 | 1000 | 0.5 | 5 | 0.8 | 2 | 1550 | 5 | 45 | 78 | NG |
| | 12 | Ga₂O₃ | 5 | 3 | 0.5 | 900 | 4 | 5 | 5 | 7 | 1200 | 5.7 | 25 | 55 | NG |
| | 13 | Al₂O₃ | 5 | 1 | 1 | 900 | 1 | 5 | 5 | 2 | 1500 | 5.6 | 23 | 38 | NG |
| | 14 | Al₂O₃ | 5 | 11 | 220 | 1000 | 3 | 5 | 4 | 2 | 1200 | 5.2 | 12 | 55 | NG |

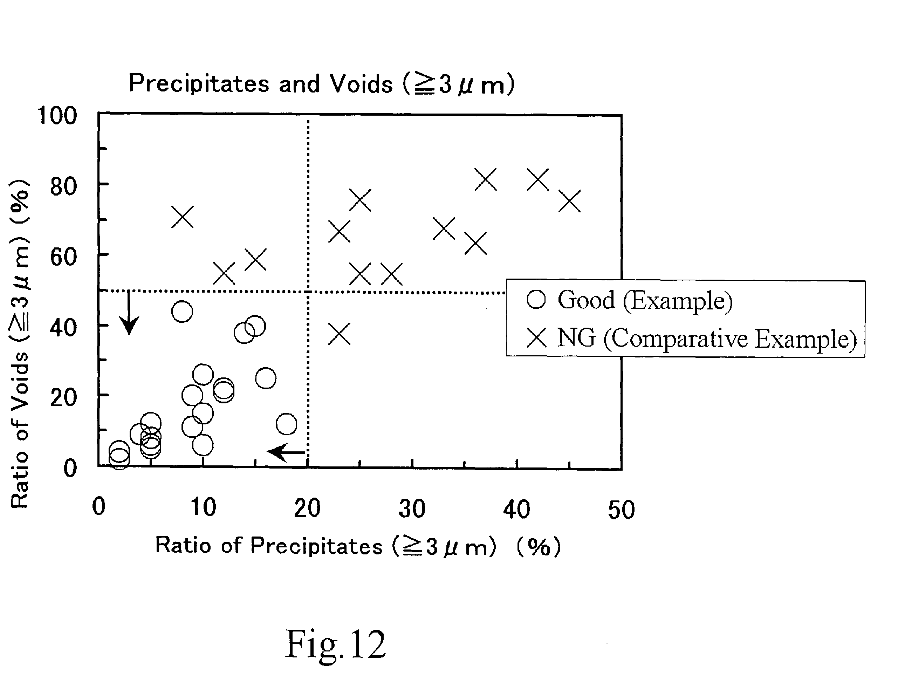

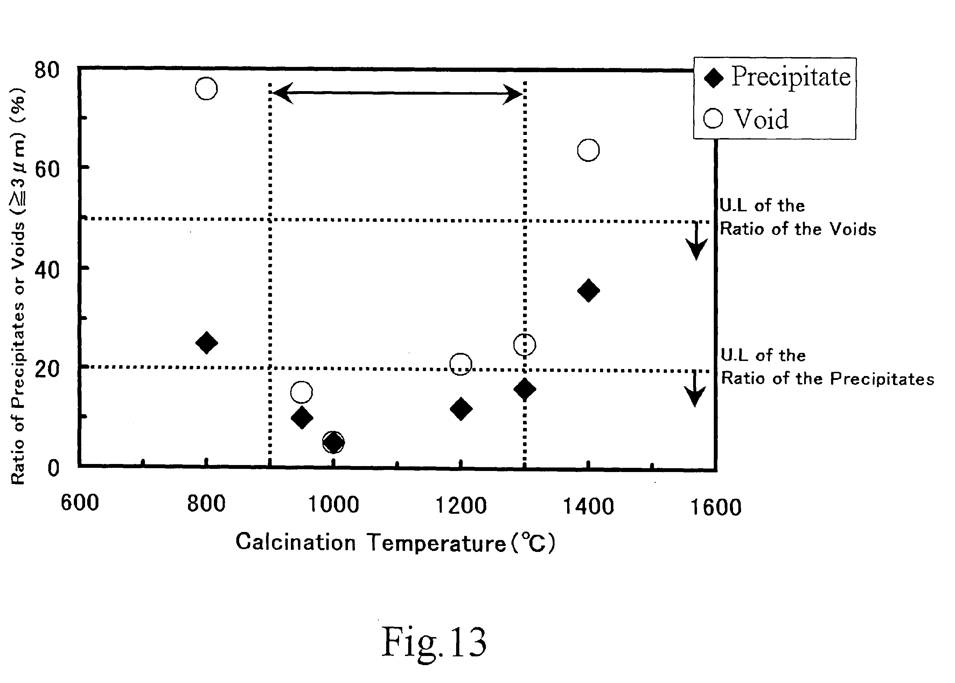

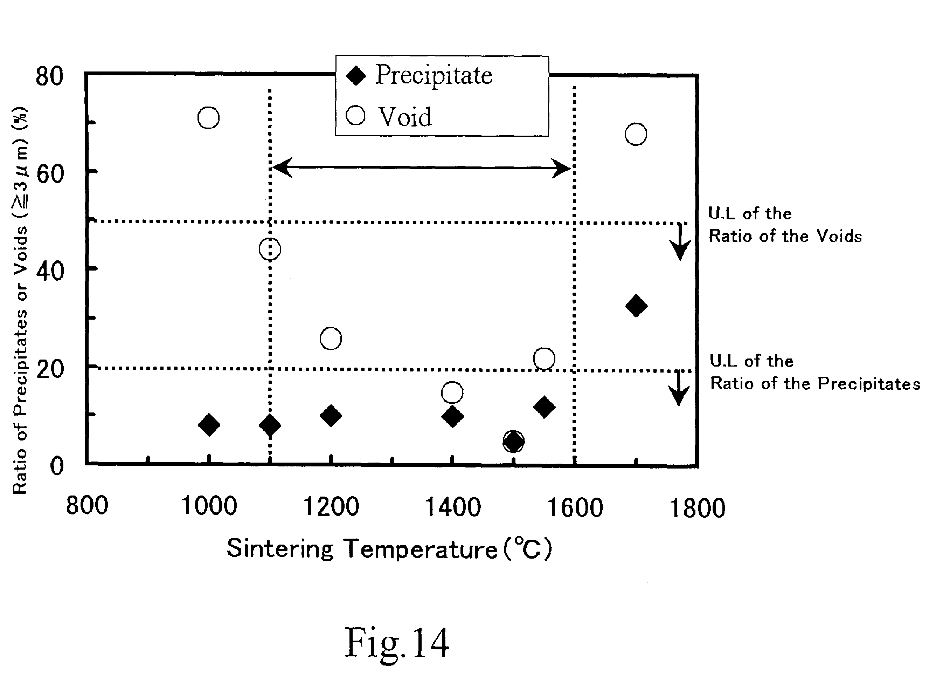

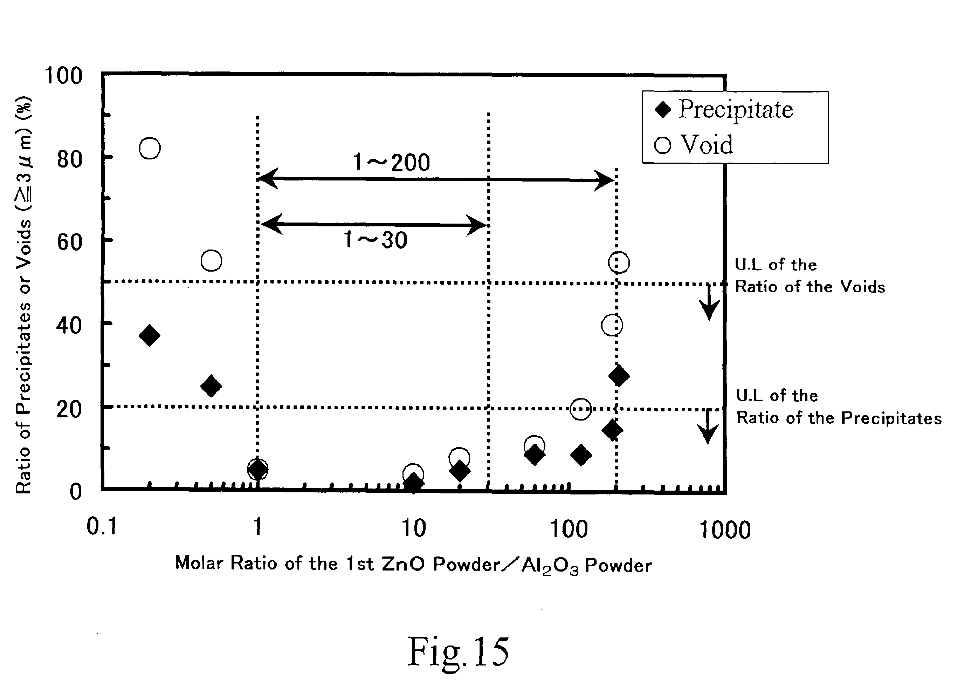

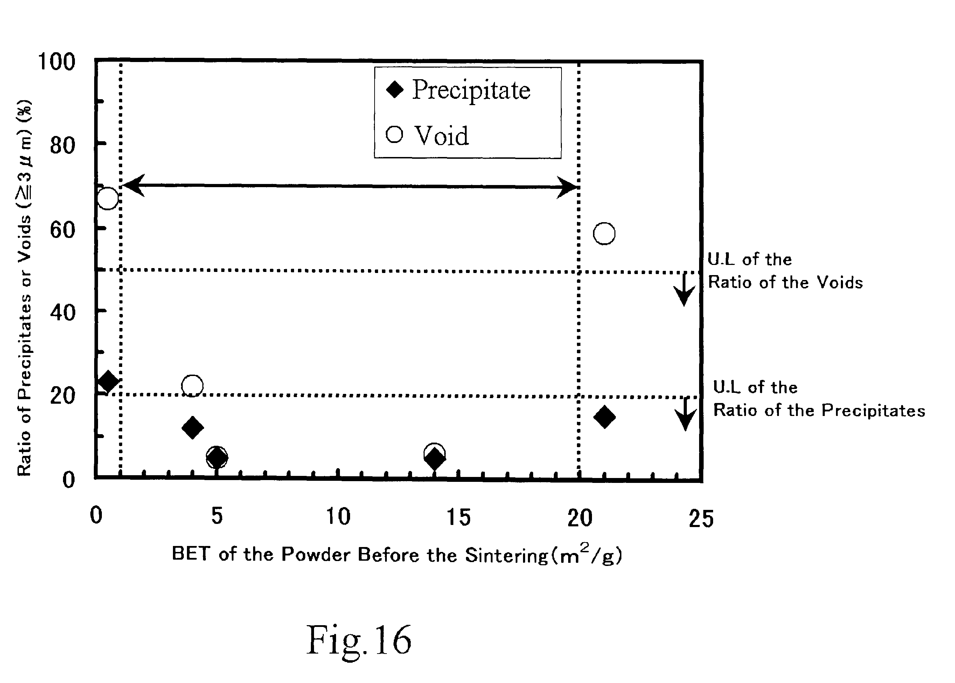

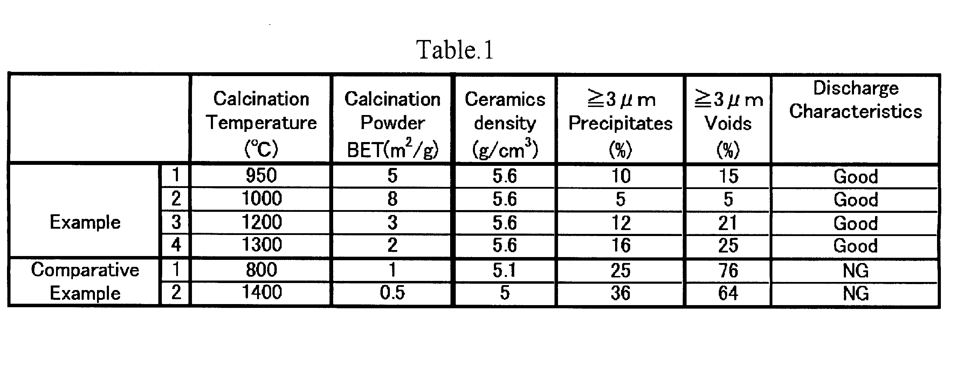

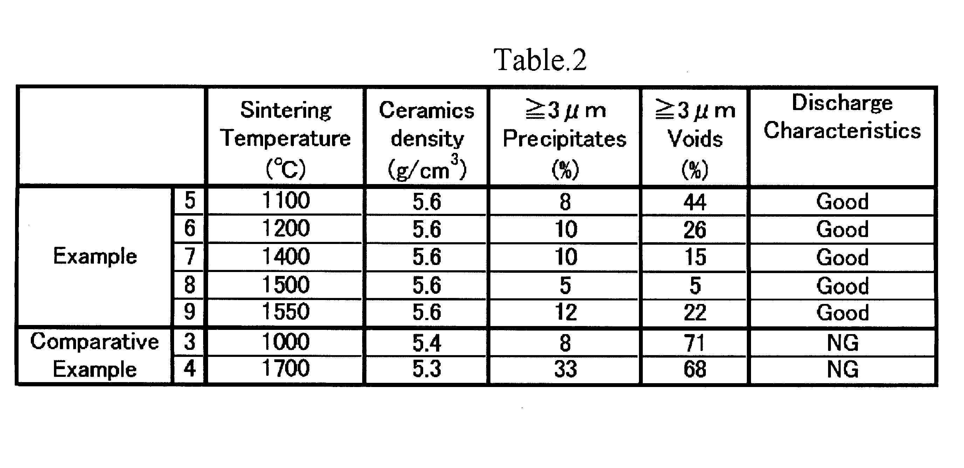

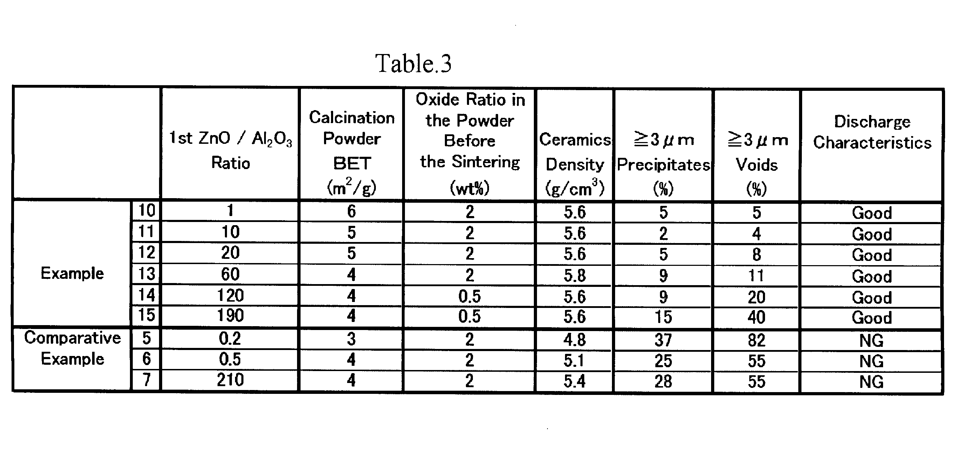

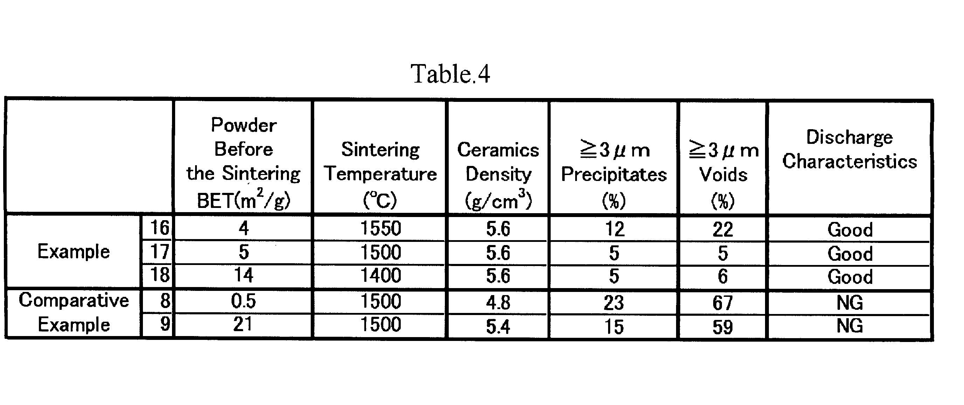

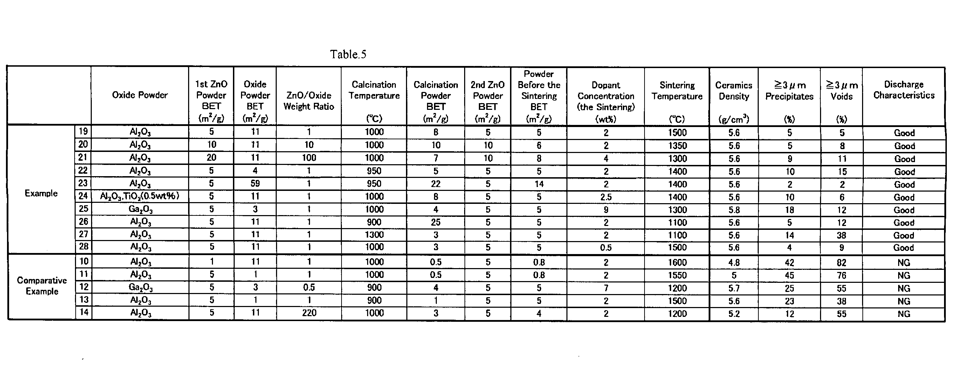

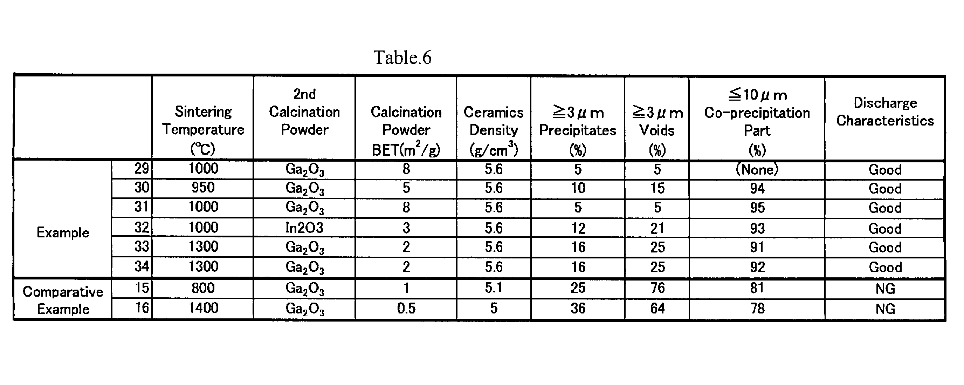

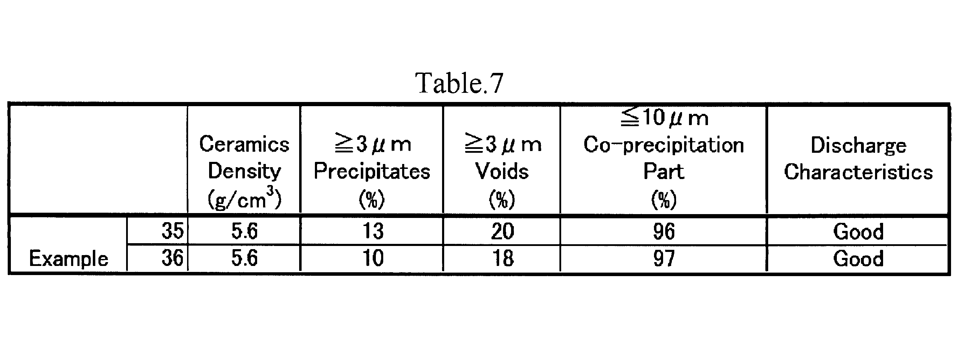

Figure 12 shows results of all examples and comparative examples on the ratio of the precipitates and the voids whose diameters of equivalent circles are 3 µm or larger. Here, samples with good discharge characteristics (examples) are shown as ○, and samples with no good one (comparative examples) are shown as ×. It was found that excellent discharge characteristics were obtained, when the ratio of the precipitates whose diameter of equivalent circles are 3 µm or larger is 20% or less, and the ratio of the voids whose diameter of equivalent circles are 3 µm or larger is 50% or less. Furthermore, these ratios depend on the calcination temperature, the sintering temperature, the molar ratio of the 1st ZnO to the oxide, or the BET specific surface area of the powder before the sintering strongly. Dependence of these ratios on the calcination temperature derived from results in table 1 is shown in figure 13, and that on the sintering temperature derived from results in table 2 is shown in figure 14. Also, dependence of these ratios on the molar ratio of the 1st ZnO / the oxide derived from results in table 3 is shown in figure 15, and that on the BET specific surface area of the powder before the sintering derived from results in table 4 is shown in figure 16. From these results, it was found that the rario of the precipitates or voids whose diameter of equivalent circles are 3 µm or larger could be made less by setting these parameters in the aforementioned ranges, and the abnormal discharge was suppressed. In tables 1 ∼ 5, it was found that the density of each of examples was high. Here, the density of example 25 or that of comparative example 12, in which Ga₂O₃ is doped, is higher because density of Ga₂O₃ is higher than that of ZnO or Al₂O₃.

Next, examples concerning the 2nd embodiment and the 3rd embodiment are explained. In the zinc oxide ceramics of examples 29 ∼ 36 and comparative examples 15 and 16 described below, the 1st ZnO powder, the 1st oxide powder (Al₂O₃), and the 2nd oxide powder (Ga₂O₃, In₂O₃) with predetermined BET specific surface area were blended with predetermined mixing weight ratio, and were mixed with the ball mill for 20 hours, dried later, and mixed powders were obtained. These mixed powders were caicinated in the air at predetermined temperature for 2 hours, and the calcinated bodies were obtained. On these calcinated bodies, mixing by the ball mill as shown before was done similarly, and the calcination powders with predetermined BET specific surface area were obtained. After blending the calcination powders and the 2nd ZnO powders with predetermined BET specific surface area with shown ratios such that the oxide compositions of the ceramics are set as predetermined, mixing them by the ball mill for 20 hours, drying, and the powders before the sintering were obtained. After mixing polyvinyl alcohols with the powders before the sintering by 1wt%, granulating, forming were done by uniaxial pressing with pressure of 1 ton/cm² at first and by CIP with pressure of 3 ton later, and the formed bodies of ϕ180mm ×7mm were obtained. After dewaxing the formed body in the air at 600°C for 1 hour, the sinterings were done at predetermined temperature in the air for 2 hours, and the zinc oxide ceramics were obtained. Here, the BET specific surface area of each powder was measured as shown previously.

Evaluation of number, shape, and area of the precipitates or the voids in unit area of the zinc oxide ceramics, or density measurement of the ceramics, or evaluation of the discharge characteristics was done as aforementioned.

Example 29 concerning the 2nd embodiment was manufactured using α-alumina (Al₂O₃) as the 1st oxide powder, and gallium oxide (Ga₂O₃) as the 2nd oxide powder, by the manufacturing method concerning the 2nd embodiment (figure 4) . Here, the BET specific surface area of the 1st ZnO powder, that of the 1st oxide powder and of the 2nd oxide powder was 5m²/g, 11m²/g, respectively, and the molar ratio in powder, the 1st ZnO / (Al₂O₃+Ga₂O₃) was 1. The BET specific surface area of both the 2nd ZnO powder and the powder before the sintering was 5m²/g, the weight ratio of the oxide in the powder before the sintering was 2%, and, the weight ratio of Al2O3 to the oxide was 2.0%, the weight ratio of Ga₂O₃ or In2O3 to it was 0.5%. Here, the calcination temperature was 1000°C and the sintering temperature was 1500 °C.

The aforementioned measurement result on the ceramics of example 29 is shown in Table 6. Using example 29, the abnormal discharge occurred once. Here, although it was better than aforementioned comparative examples, improvement is needed. In the cross section of the ceramics, rough and large voids or precipitates were not seen. However, convex shaped nodules formed by pits that was formed by selective erosion of ZnGa204 phase, were seen. Here, the weather resistance of the formed transparent electrodes was excellent.

Examples 30 ∼ 36 explained in the below and comparative examples 15 and 16 were produced by the manufacturing method concerning the 3rd embodiment(figure 7). However, in the comparative example, the sintering temperature was out of the range of 1100 ∼ 1600°C.

Concretely, the 1st mixture solutions were produced, by putting the calcination powders produced by aforementioned process such that the ceramics compositions were set as predetermined and pure water with 50 times the weight of the calcination powder in a resin pot, and mixing them for 20 hours by a ball mill using alumina balls. And, the 2nd mixture solution were produced, by putting the 2nd ZnO powders, the 1st mixture solutions, and pure water with 5 times the weight of sum of the calcination powder and the 2nd ZnO powder, and mixing them for 20 hours by a ball mill using alumina balls. Subsequently, the powders before the sintering were produced by drying the 2nd mixture solutions at 1000°C for 2 hours, and by breaking them, then the formed bodies were produced.

In examples 30 ∼ 34 and comparative examples 15 and 16, effects of the calcination temperature on the characteristics of the AZO ceramics were investigated, using α-alumina (Al₂O₃) as the 1st oxide powder, and α-gallium oxide (Ga₂O₃) or indium oxide (In₂O₃) as the 2nd oxide powder. Here, the BET specific surface area of the 1st ZnO powder or that of the 1st oxide powder and the 2nd oxide powder, was 5m²/g, 11m²/g, respectively, and the powder molar ratio of 1st ZnO/(Al₂O₃+Ga₂O₃) or that of the 1st ZnO/(Al₂O₃+In₂O₃) was 1. The BET specific surface area of both the 2nd ZnO powder and the powder before the sintering was 5m²/g, the weight ratio of the oxide in the powder before the sintering 2%, and the weight ratio of Al₂O₃ in it was 2.0%, the weight ratio of Ga₂O₃ or In₂O₃ in it was 0.5%. The sintering temperature was 1500 °C.

The aforementioned measurement results on the ceramics of examples 30 ∼ 34 and comparative examples 15 and 16 are shown in Table 6. In examples 30 ∼ 34 in which the calcination temperatures are in the range of 900 ∼ 1300 °C, the abnormal discharge did not occur, and the electrodes with excellent weather resistance were obtained. By observations of cross sections of the ceramics, rough and large voids, precipitates, or nodules were not found, and the ratio of the precipitates whose diameter of equivalent circles are 3 µm or larger was 20% or less, and the ratio of the voids whose diameter of equivalent circles are 3 µm or larger was 50% or less, and the ratio of the co-precipitation parts whose diameter of equivalent circles are 10 µm or smaller was 90% or more. In comparative examples 15 and 16 out of these ranges, the abnormal discharge occurred frequently, and the ratios of the precipitates or the voids were more than 20%, 50%, respectively, and the ratios of the co-precipitation part were less than 90%.

[Table 6]

**Table.6**

| | | Sintering Temperature | 2nd Calcination Powder | Calcination Powder BET | Ceramics Density | ≧3µm Precipitates | ≧3µm Voids | ≦10µm Co-precipitation Part | Discharge characteristics |
|---|---|---|---|---|---|---|---|---|---|
| | | (°C) | | (m²/g) | (g/cm³) | (%) | (%) | (%) | |
| Example | 29 | 1000 | Ga₂O₃ | 8 | 5.6 | 5 | 5 | (None) | Good |
| | 30 | 950 | Ga₂O₃ | 5 | 5.6 | 10 | 15 | 94 | Good |
| | 31 | 1000 | Ga₂O₃ | 8 | 5.6 | 5 | 5 | 95 | Good |
| | 32 | 1000 | In2O3 | 3 | 5.6 | 12 | 21 | 93 | Good |
| | 33 | 1300 | Ga₂O₃ | 2 | 5.6 | 16 | 25 | 91 | Good |
| | 34 | 1300 | Ga₂O₃ | 2 | 5.6 | 16 | 25 | 92 | Good |
| Comparative Example | 15 | 800 | Ga₂O₃ | 1 | 5.1 | 25 | 76 | 81 | NG |
| | 16 | 1400 | Ga₂O₃ | 0.5 | 5 | 36 | 64 | 78 | NG |

In example 35, the 1st mixture solution was produced in the 1st mixing process used in example 31, by mixing a solution in which the 1st calcination powder was mixed with pure water and another solution in which the 2nd calcination powder was mixed with pure water. Concretely, a solution was produced, by putting the calcination powder made of Al₂O₃ such that the ceramics compositions were set as predetermined, and pure water with 50 times the weight of the calcination powder in a resin pot, and mixing them for 20 hours by a ball mill using alumina balls, and another solution containing another calcination powder made of Ga₂O₃ was produced similarly, and the 1st mixture solution was produced by mixing these solutions. Other conditions were similar to those of example 31.

In example 36, the 2nd mixture solution was produced in the 2nd mixing process used in example 31, by mixing the 1st mixture solution and a solution in which the 2nd ZnO powder was mixed with pure water. Concretely, a solution was produced by putting the 2nd ZnO powder blended such that the ceramics compositions was set as predetermined, and pure water with 5 times the weight of the 2nd ZnO powder in a resin pot, and mixing them for 20 hours by a ball mill using alumina balls, and the 2nd mixture solution was produced by mixing this solution and the 1st mixture solution. Other conditions were similar to those of example 31.

The aforementioned measurement results on the ceramics of examples 35, 36 are shown in Table 7. In these examples, the abnormal discharge did not occur, and the electrodes with excellent weather resistance were obtained. And, said ratio of the precipitates or the voids was 20% or less, 50% or less, respectively, and said ratio of the co-precipitation parts was 90% or more.

[Table 7]

**Table.7**

| | | Ceramics Density (g/cm³) | ≧3µm Precipitates (%) | ≧3µm Voids (%) | ≦10µm Co-precipitation Part (%) | Discharge Characteristics |
|---|---|---|---|---|---|---|
| Example | 35 | 5.6 | 13 | 20 | 96 | Good |
| | 36 | 5.6 | 10 | 18 | 97 | Good |

### [Brief Description of the Drawings]

Figure 1 shows a process chart of the manufacturing method for the zinc oxide ceramics of the 1st embodiment concerning this invention.
Figure 2 shows a Scanning Electron Microscopy photograph of a cross section of zinc oxide ceramics manufactured by the conventional manufacturing method.
Figure 3 shows a Scanning Electron Microscopy photograph of a cross section of zinc oxide ceramics manufactured by the manufacturing method for the zinc oxide ceramics of the 1st embodiment concerning this invention.
Figure 4 shows a process chart of the manufacturing method for the zinc oxide ceramics of the 2nd embodiment concerning this invention.
Figure 5 shows a process chart of another example of the manufacturing method for the zinc oxide ceramics of the 2nd embodiment concerning this invention.
Figure 6 shows a Scanning Electron Microscopy photograph of a cross section of zinc oxide ceramics manufactured by the manufacturing method for the zinc oxide ceramics of the 2nd embodiment concerning this invention.
Figure 7 shows a process chart of the manufacturing method for the zinc oxide ceramics of the 3rd embodiment concerning this invention.
Figure 8 shows a EPMA analysis result of zinc oxide ceramics (Al and Ga are doped) manufactured by the manufacturing method for the zinc oxide ceramics of the 3rd embodiment concerning this invention.
Figure 9 shows a EPMA analysis result of zinc oxide ceramics (Al and Ga are doped) manufactured by the manufacturing method for the zinc oxide ceramics of the 2nd embodiment concerning this invention.
Figure 10 shows a EPMA analysis result of zinc oxide ceramics (Al and In are doped) manufactured by the manufacturing method for the zinc oxide ceramics of the 3rd embodiment concerning this invention.
Figure 11 shows a process chart of preferable example of the manufacturing method for the zinc oxide ceramics of the 3rd embodiment concerning this invention.
Figure 12 shows the ratios of the precipitates or the voids whose diameter of equivalent circles are 3µm or larger on examples and comparative examples.
Figure 13 shows dependence of the ratio of the precipitates or the voids whose diameter of equivalent circles are 3µm or larger, on the calcination temperature.
Figure 14 shows dependence of the ratio of the precipitates or the voids whose diameter of equivalent circles are 3µm or larger, on the sintering temperature.
Figure 15 shows dependence of the ratio of the precipitates or the voids whose diameter of equivalent circles are 3µm or larger, on the molar ratio (the 1st ZnO powder / the oxide powder).
Figure 16 shows dependence of the ratio of the precipitates or the voids whose diameter of equivalent circles are 3µm or larger, on the BET specific surface area of the powder before the sintering.

### [Description of Notations]

1 ZnO Phase
2 Precipitate (ZnAl₂O₄ phase)
3 Void
4 Precipitate (ZnGa₂O₄ phase)
5 EPMA Intensity of Al
6 EPMA Intensity of Ga
7 EPMA Intensity of Zn
8 EPMA Intensity of In

## Claims

1. A manufacturing method for zinc oxide ceramics, in which said ceramics contain more than one of Al, Ga, In, Ti, Si, Ge and Sn as dopants in ZnO, comprising;
calcination powder production process by which calcination powder is produced after blending oxide powder made of oxide of said dopant and a 1st ZnO powder, and calcinating them at temperature of 900 ∼ 1300°C,
sintering process by which said zinc oxide ceramics are manufactured after sintering at temperature of 1100 ∼ 1600 °C formed body composed of powder before the sintering which is made by blending said calcination powder and a 2nd ZnO powder.

2. The manufacturing method for zinc oxide ceramics according to claim 1,
wherein, mixing molar ratio of said 1st ZnO powder to said oxide powder is 1 or more, and is 200 or less in said calcination powder production process.

3. The manufacturing method for zinc oxide ceramics according to claim 1 or 2,
wherein, BET specific surface area of said 1st ZnO powder is in a range of 2 ∼ 30 m²/g.

4. The manufacturing method for zinc oxide ceramics according to one of claims 1 through 3,
wherein, BET specific surface area of said oxide powder is in a range of 2 ∼ 100m²/g.

5. The manufacturing method for zinc oxide ceramics according to one of claims 1 through 4,
wherein, said oxide powder is made of at least one selected among Al₂O₃, Ga₂O₃, In₂O₃, TiO₂, SiO₂, GeO₂, and SnO₂.

6. The manufacturing method for zinc oxide ceramics according to one of claims 1 through 5,
wherein, calcination in said calcination powder production process is carried in non-reducing atmosphere.

7. The manufacturing method for zinc oxide ceramics according to one of claims 1 through 6,
wherein, BET specific surface area of said powder before the sintering is in a range of 1 ∼ 20m²/g.

8. The manufacturing method for zinc oxide ceramics according to one of claims 1 through 7,
wherein, sintering in said sintering process is carried in non-reducing atmosphere.

9. The manufacturing method for zinc oxide ceramics according to one of claims 1 through 8,
wherein, said dopants comprise a 1st dopant which is one selected among Al, Ga, In, Ti, Si, Ge, and Sn, and a 2nd dopant which is one selected among Al, Ga, In, Ti, Si, Ge, and Sn except for said 1st dopant,
wherein, said oxide powder in said calcination powder production process comprises a 1st oxide powder made of oxide of said 1st dopant and a 2nd oxide powder made of oxide of said 2nd dopant.

10. The manufacturing method for zinc oxide ceramics according to claim 9,
wherein, a 1st calcinated body is produced after blending said 1st oxide powder and said 1st ZnO powder and calcinating them at temperature of 900 ∼ 1300°C, and a 2nd calcinated body is produced after blending said 2nd oxide powder and 3rd ZnO powder and calcinating them at temperature of 900 ∼ 1300°C, and said calcination powder is produced by mixing said 1st calcinated body and said 2nd calcinated body in said calcination powder production process.

11. The manufacturing method for zinc oxide ceramics according to claim 10,
wherein, mixing molar ratio of sum of said 1st ZnO powder and said 3rd ZnO powder to sum of said 1st oxide powder and said 2nd oxide powder is 1 or more, and 200 or less, in said calcination powder production process.

12. The manufacturing method for zinc oxide ceramics according to claim 10,
wherein, both mixing molar ratio of said 1st ZnO powder to said 1st oxide powder, and mixing molar ratio of said 3rd ZnO powder to said 2nd oxide powder, are 1 or more, and 200 or less, in said calcination powder production process.

13. The manufacturing method for zinc oxide ceramics according to one of claims 10 through 12,
wherein, BET specific surface area of said 3rd ZnO powder is in a range of 2 ∼ 30m²/g.

14. The manufacturing method for zinc oxide ceramics according to one of claims 10 through 13,
further comprising;
a 1st mixing process, in which a 1st mixture solution is produced by mixing said calcination powder produced by said calcination powder production process with a solvent,
a 2nd mixing process, in which a 2nd mixture solution is produced by mixing a 2nd ZnO powder with said 1st mixture solution,
wherein, a powder produced from said 2nd mixture solution is formed into a formed body, and said ceramics are manufactured by sintering said formed body.

15. The manufacturing method for zinc oxide ceramics according to claim 14,
wherein, said 2nd mixture solution is produced by mixing said 1st mixture solution with another solution in which said 2nd ZnO powder is mixed with a solvent.

16. A manufacturing method for zinc oxide ceramics, in which said ceramics contain more than one of Al, Ga, In, Ti, Si, Ge and Sn as dopants in ZnO, comprising;
mixing a powder made of complex oxide composed mainly of both said dopant and Zn, with ZnO powder,
forming said mixed powder into a formed body,
manufacturing said ceramics by sintering said formed body at a temperature of 1100 ∼ 1600°C.

17. The manufacturing method for zinc oxide ceramics according to claim 16,
wherein, said complex oxide is made of at least one among ZnAl₂O₄, ZnGa₂O₄, ZnIn₂O₄, Zn₂TiO₄, Zn₂SiO₄, Zn₂GeO₄, and Zn₂SnO₄.

18. A zinc oxide ceramics manufactured by the manufacturing method for zinc oxide ceramics according to one of claims 1 through 17.

19. A zinc oxide ceramics containing more than one of Al, Ga, In, Ti, Si, Ge and Sn as dopants in ZnO,
wherein, both precipitates containing complex oxide of said dopant and Zn and voids around said precipitates, are formed inside,
wherein, ratio of said precipitates in which diameter of equivalent circle is 3µm or larger to all of said precipitates is 20% or less, and ratio of said voids in which diameter of equivalent circle is 3µm or larger to all of said voids, is 50% or less.

20. The zinc oxide ceramics according to claim 19,
wherein, composition ratio of said dopant in said ceramics is 0.5 ∼ 10wt%, expressed as oxides.

21. A zinc oxide ceramics containing one among Al, Ga, In, Ti, Si, Ge and Sn as a 1st dopant, and also containing one among Al, Ga, In, Ti, Si, Ge and Sn except for said 1st dopant as a 2nd dopant in ZnO,
wherein, a co-precipitation part in which a 1st precipitate containing complex oxide of said 1st dopant and Zn, and a 2nd precipitate containing complex oxide of said 2nd dopant and Zn, are co-existing, is formed in zinc oxide phase which is a main phase.

22. The zinc oxide ceramics according to claim 21,
wherein volume ratio of said co-precipitation parts whose diameter of equivalent circle is 10µm or smaller is 90% or more.

23. The zinc oxide ceramics according to claim 21 or 22,
wherein, composition ratio of said 2nd dopant in said ceramics is 0.05 ∼ 5wt%, expressed as oxides.

24. The zinc oxide ceramics according to one of claims 21 through 23,
wherein, composition ratio of sum of said 1st dopant and said 2nd dopant in said ceramics is 0.5 ∼ 10wt%, expressed as oxides.

25. The zinc oxide ceramics according to one of claims 18 through 24,
wherein, density of said ceramics is 5.5g/cm³ or higher.

26. A sputtering target made of the zinc oxide ceramics according to one of claims 18 through 25.
